(19)

Europäisches Patentamt
European Patent Office
Office européen des brevets

(11) **EP 4 326 005 A1**

(12) **EUROPEAN PATENT APPLICATION**
published in accordance with Art. 153(4) EPC

(43) Date of publication:
**21.02.2024 Bulletin 2024/08**

(21) Application number: **22788036.6**

(22) Date of filing: **29.03.2022**

(51) International Patent Classification (IPC):
*H05B 33/24* (2006.01)        *G09F 9/30* (2006.01)
*H01L 27/32* (2006.01)        *H01L 51/50* (2006.01)
*H05B 33/02* (2006.01)        *H05B 33/22* (2006.01)

(52) Cooperative Patent Classification (CPC):
**G09F 9/30; H05B 33/02; H05B 33/22; H05B 33/24;**
**H10K 50/00; H10K 59/00**

(86) International application number:
**PCT/JP2022/015552**

(87) International publication number:
**WO 2022/220111 (20.10.2022 Gazette 2022/42)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **13.04.2021   JP 2021067635**
        **08.02.2022   JP 2022018103**

(71) Applicant: **CANON KABUSHIKI KAISHA**
**Tokyo 146-8501 (JP)**

(72) Inventors:
• **KAJIMOTO, Norifumi**
  **Tokyo 146-8501 (JP)**

• **ISHIZUYA, Koji**
  **Tokyo 146-8501 (JP)**
• **ITO, Takayuki**
  **Tokyo 146-8501 (JP)**
• **SANO, Hiroaki**
  **Tokyo 146-8501 (JP)**
• **TAKAHASHI, Tetsuo**
  **Tokyo 146-8501 (JP)**
• **MATSUDA, Yojiro**
  **Tokyo 146-8501 (JP)**

(74) Representative: **Canon Europe Limited**
**European Intellectual Property Group**
**4 Roundwood Avenue**
**Stockley Park**
**Uxbridge UB11 1AF (GB)**

(54) **LIGHT-EMITTING DEVICE, DISPLAY DEVICE, IMAGING DEVICE, AND ELECTRONIC APPARATUS**

(57)    The present disclosure provides a light-emitting apparatus including an insulating layer, a light-emitting element disposed on a main surface of the insulating layer, the light-emitting element containing a light-emitting material and having a resonator structure, and a lens disposed above the light-emitting element, a photoluminescence (PL) spectrum of the light-emitting material having a first peak with a wavelength $\lambda_{pl}$ in a visible light range, wherein the resonator structure satisfies Exp. (1),

$$|\lambda_{EL} - \lambda_{PL}| < |\lambda_{on} - \lambda_{PL}| \quad (1)$$

where $\lambda_{on}$ is a resonance peak wavelength of an interference spectrum that reinforces light emitted in a direction perpendicular to the main surface and $\lambda_{EL}$ is a peak wavelength of electroluminescence radiated via the light extracting structure.

FIG. 1A

**(Cont. next page)**

EP 4 326 005 A1

# FIG. 1B

**Description**

Technical Field

The present invention relates to light-emitting apparatuses, display apparatuses, image pickup apparatuses, and electronic apparatuses.

Background Art

Organic light-emitting elements (also referred to as organic electroluminescence (EL) elements or organic light-emitting diodes (OLEDs)) are electronic elements including a pair of electrodes and an organic compound layer disposed between the electrodes. Injecting electrons and holes from the pair of electrodes into the organic compound layer generates excitons of the luminescent organic compound in the organic compound layer, and when the excitons return to the ground state, the organic light-emitting element emits light. The recent remarkable progress in the organic light-emitting elements has prompted a lower driving voltage, a variety of emission wavelengths, rapid response, and a decrease in the thickness and weight of light-emitting devices. In contrast, organic light-emitting elements trap light so that much light cannot be extracted to the outside, having low light extraction efficiency. To increase the light extraction efficiency, organic light-emitting elements may include a light extracting structure, such as microlenses. PTL 1 discloses an organic light-emitting device including microlenses as an outcoupling component to increase the amount of light extracted from the OLED. In the organic light-emitting device disclosed in PTL 1, the diameter of each microlens and the distance between the lens and the luminous region are defined to address the problem of low contrast due to back scattering.

Citation List

Patent Literature

PTL 1: Japanese Patent Laid-Open No. 2017-17013

Summary of Invention

Technical Problem

However, the organic light-emitting device disclosed in PTL 1 does not define interference conditions, having no sufficient configuration for radiating desired light in a substrate normal direction (that is, a frontal direction). Solution to Problem

The present invention is made in view the above problem, and its object is to provide an organic light-emitting element having high radiance in the frontal direction using a light extracting structure, such as microlenses, and using optical interference taking account of the light extracting structure.

An embodiment of the present invention provides a light-emitting apparatus including an insulating layer, a light-emitting element disposed on a main surface of the insulating layer, the light-emitting element containing a light-emitting material and having a resonator structure, a light extracting structure disposed above the light-emitting element, and an electrode between the main surface of the insulating layer and the light-emitting material, the electrode supplying electrical charge to the light-emitting material, a photoluminescence (PL) spectrum of the light-emitting material having a first peak with a wavelength $\lambda_{pl}$ in a visible light range,
wherein the resonator structure satisfies Exp. (1),

$$|\lambda_{EL} - \lambda_{pl}| < |\lambda_{on} - \lambda_{pl}| \quad (1)$$

where $\lambda_{on}$ is a resonance peak wavelength of an interference spectrum that reinforces light emitted in a direction perpendicular to the main surface and $\lambda_{EL}$ is a peak wavelength of electroluminescence radiated via the light extracting structure.

Advantageous Effects of Invention

The present invention provides an organic light-emitting element having high radiance in the frontal direction using a light extracting structure and optical interference taking account of the light extracting structure.

Brief Description of Drawings

[Fig. 1A] Fig. 1A is a plan view of a light-emitting apparatus according to an embodiment of the present invention.

[Fig. 1B] Fig. 1B is an enlarged view of the broken line portion in Fig. 1A.

[Fig. 2A] Fig. 2A is a schematic cross-sectional view of an example in which the light extracting structure of the light-emitting apparatus is a microlens that is convex in the direction opposite to the substrate.

[Fig. 2B] Fig. 2B is a schematic cross-sectional view of an example in which the light extracting structure of the light-emitting apparatus is a microlens that is convex in the direction of the substrate.

[Fig. 3A] Fig. 3A is a schematic diagram illustrating light emitted from a luminous point in the frontal direction of the light-emitting apparatus.

[Fig. 3B] Fig. 3B is a schematic diagram illustrating light emitted from the luminous point in a direction inclined with respect to the substrate main surface.

[Fig. 4A] Fig. 4A is a schematic diagram illustrating a method for estimating $\Theta_{eml}$ using a spherical microlens as an example of the light extracting structure.

[Fig. 4B] Fig. 4B is a schematic diagram illustrating a method for estimating $\Theta_{eml}$ using a spherical microlens as an example of the light extracting structure.

[Fig. 4C] Fig. 4C is a schematic diagram illustrating a method for estimating $\Theta_{eml}$ using a spherical microlens as an example of the light extracting structure.

[Fig. 4D] Fig. 4D is a schematic diagram illustrating a method for estimating $\Theta_{eml}$ using a spherical microlens as an example of the light extracting structure.

[Fig. 5] Fig. 5(a) is a graph showing the PL spectrum of a light emitting material and interference spectra $\lambda_{off}$ and $\lambda_{on}$ according to a comparative example. Fig. 5(b) is a graph showing the PL spectrum of the light-emitting material and the interference spectra $\lambda_{off}$ and $\lambda_{on}$ of the light-emitting element for reinforcing light emitted in a direction inclined with respect to the substrate main surface together. Figs. 5(c) and (d) show the EL spectra of (a) and (b).

[Fig. 6A] Fig. 6A is a schematic diagram of emitted light refracted by a shifted microlens in a conventional configuration in which the interference peak resonant wavelength $\lambda_{on}$ in the frontal direction of the substrate main surface and $\lambda_{PL}$ are made to coincide.

[Fig. 6B] Fig. 6B is a schematic diagram of emitted light refracted by a microlens in a configuration in which the interference peak resonant wavelength $\lambda_{off}$ in a direction inclined with respect to the substrate main surface and $\lambda_{PL}$ are made to coincide.

[Fig. 7A] Fig. 7A is a plan view of a display area illustrating the relative position of the microlenses and the pixels vary with the position in the display area.

[Fig. 7B] Fig. 7B is a schematic cross-sectional view taken along line E-E' in Fig. 7A.

[Fig. 8A] Fig. 8A is a diagram illustrating another configuration example of the light-emitting apparatus according to an embodiment of the present invention.

[Fig. 8B] Fig. 8B is a diagram illustrating another configuration example of the light-emitting apparatus according to an embodiment of the present invention.

[Fig. 8C] Fig. 8C is a diagram illustrating another configuration example of the light-emitting apparatus according to an embodiment of the present invention.

[Fig. 8D] Fig. 8D is a diagram illustrating another configuration example of the light-emitting apparatus according to an embodiment of the present invention.

[Fig. 9] Fig. 9 is a graph showing the relationship between the emission angles and the relative intensities of an emission layer obtained from ray tracing.

[Fig. 10] Fig. 10 shows the PL spectrum PL1 of the light-emitting material used in Example 1.

[Fig. 11] Fig. 11 is a schematic diagram illustrating an example of a display apparatus according to an embodiment of the present invention.

[Fig. 12A] Fig. 12A is a schematic diagram illustrating an example of an image pickup apparatus according to an embodiment of the present invention.

[Fig. 12B] Fig. 12B is a schematic diagram illustrating an example of an electronic apparatus according to an embodiment of the present invention.

[Fig. 13A] Fig. 13A is a schematic diagram illustrating an example of a display apparatus according to an embodiment of the present invention.

[Fig. 13B] Fig. 13B is a schematic diagram illustrating an example of a foldable display apparatus.

[Fig. 14A] Fig. 14A is a schematic diagram illustrating an example of a wearable device according to an embodiment of the present invention.

[Fig. 14B] Fig. 14B is a schematic diagram illustrating an example of a wearable device with an image pickup apparatus, according to an embodiment of the present invention.

Description of Embodiments

A light-emitting apparatus according to an embodiment of the present invention can reinforce the radiation intensity in the frontal direction of the organic EL element with a light extracting structure by including an organic-film interference structure matched to the inclined portion of the light extracting structure. This is because the light with the PL peak wavelength of the light-emitting material is effectively reinforced and is refracted in the frontal direction at the inclined portion of the light extracting structure. The light-emitting apparatus includes an electrode that supplies electrical charge to the light-emitting material between the main surface of the insulating layer and the light-emitting material, and one end and the other end of the electrode is covered with a pixel separating layer.

In other words, a light-emitting apparatus according to an embodiment of the present invention includes an insulating layer, a light-emitting element disposed on a main surface of the insulating layer, the light-emitting element containing a light-emitting material and having a resonator structure, and a light extracting structure disposed above the light-emitting element, a photoluminescence (PL) spectrum of the light-emitting material having a first peak with a wavelength $\lambda_{PL}$ in a visible light range, wherein the resonator structure satisfies Exp. (1),

$$|\lambda_{EL} - \lambda_{PL}| < |\lambda_{on} - \lambda_{PL}| \quad (1)$$

where $\lambda_{on}$ is a resonance peak wavelength of an interference spectrum that reinforces light emitted in a direction perpendicular to the main surface and $\lambda_{EL}$ is a peak wavelength of electroluminescence radiated via the light extracting structure.

A light-emitting apparatus according to an embodiment of the present invention may include an insulating layer, a light-emitting element disposed on a main surface of the insulating layer, the light-emitting element containing a light-emitting material and having a resonator structure, and a light extracting structure disposed above the light-emitting element, a photoluminescence (PL) spectrum of the light-emitting material having a first peak with a wavelength $\lambda_{PL}$ in a visible light range, wherein the resonator structure satisfies Exp. (2),

$$|\lambda_{off} - \lambda_{PL}| < |\lambda_{on} - \lambda_{PL}| \quad (2)$$

where $\lambda_{on}$ is a resonance peak wavelength of an interference spectrum that reinforces light emitted in a direction perpendicular to the main surface and $\lambda_{off}$ is a resonance peak wavelength of an interference spectrum that reinforces light emitted in the direction perpendicular to the main surface due to refraction in the light extracting structure.

In another embodiment, $\lambda_{off}$ may be set at the distance from the luminous area to the lower end of the upper electrode of the light-emitting element in the direction of the curve of the light extracting structure, and $\lambda_{on}$ may be set at the distance from the luminous area to the lower end of the upper electrode of the light-emitting element in the direction perpendicular to the insulating layer. The use of the actual distances facilitates designing.

A light-emitting apparatus according to an embodiment of the present invention will be described hereinbelow with reference to the drawings. Known technology in the technical field is applicable to components that are not particularly illustrated or described in this specification. It is to be understood that the present invention is not limited to the embodiments described below.

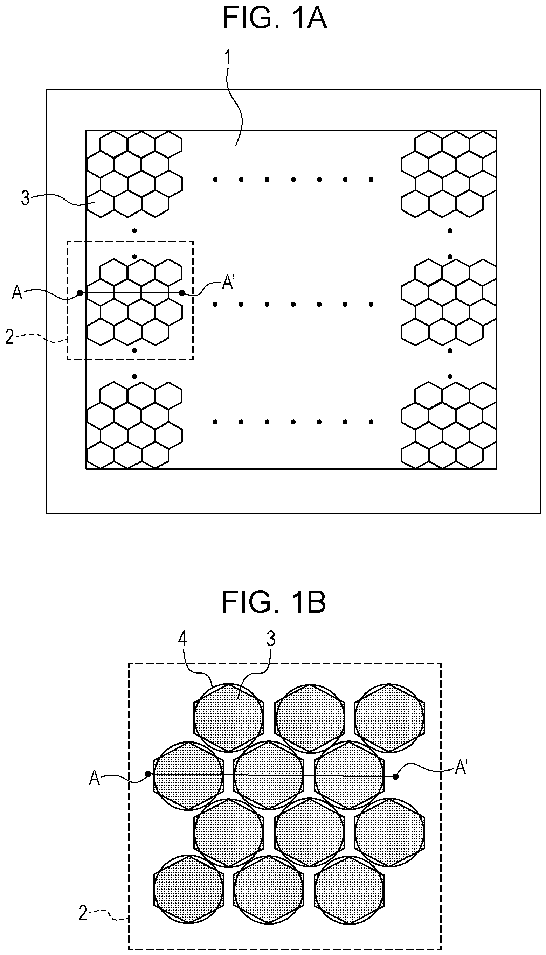

Fig. 1A is a plan view of a light-emitting apparatus according to an embodiment of the present invention. In this embodiment, the light-emitting apparatus is a display apparatus in which multiple light-emitting elements including a first light-emitting element and a second light-emitting element are arrayed, which individually emit different colors to form an image or the like. The display apparatus includes a display area 1, in which light-emitting elements 3 are arrayed in two dimensions on the main surface of an insulating layer on a substrate or the like to display an image or the like. The light-emitting elements in Figs. 1A and 1B are arranged in a delta array but may be in a stripe array, a square array, a PenTile array, or a Bayer array. An end of the display area is indicated by a broken line and is referred to as "end 2".

Fig. 1B is an enlarged view of the broken line portion of the end 2 in Fig. 1A. The end 2 includes light-emitting elements 3 arranged on the main surface of the insulating layer and light extracting structures 4 each of which receives light from the luminous region of the light-emitting element 3. In Fig. 1B, the center of the luminous region and the center of the light extracting structure coincide in plan view from the direction perpendicular to the main surface of the substrate. In this embodiment, the luminous region has, but is not limited to, a hexagonal shape. If the luminous region has a polygonal shape, the center may be estimated to be the center of the inscribed circle of the polygon. If the luminous region has a circular shape, the center of the circle may be estimated to be the center of the luminous region.

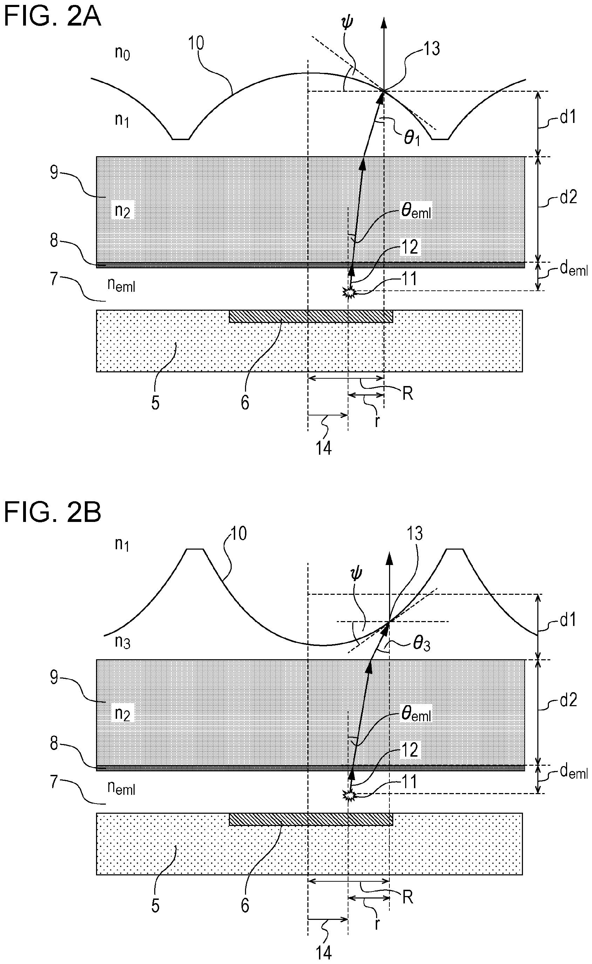

Figs. 2A and 2B are schematic cross-sectional views of a light-emitting apparatus according to an embodiment of the present invention. The schematic cross-sectional view is a view of the light-emitting elements seen from the direction perpendicular to the main surface of the insulating layer (the direction normal to the main surface). Fig. 2A illustrates an example in which the light extracting structure of the light-emitting apparatus is a microlens that is convex in the direction opposite to the substrate. The light-emitting element according to this embodiment includes, above a substrate 5, a reflecting layer 6, an organic layer 7 containing a light-emitting material, a transflective electrode 8, a protecting layer 9, and a microlens 10. The reflecting layer 6 and the transflective electrode 8 are also referred to as a lower electrode and an upper electrode, respectively, from their dispositions. The photoluminescence (PL) spectrum of the light-emitting material has a first peak with a wavelength $\lambda_{PL}$ in the visible light range. The light-emitting element may have a resonator structure that reinforces the light together in accordance with the optical distance between the reflecting layer 6 and the transflective electrode 8. Here, the light-emitting element includes, but is not limited to, the organic layer 7, which may be an inorganic light-emitting element. In the case of an organic light-emitting material, the light-emitting apparatus of this embodiment can be referred to as an organic light-emitting apparatus, and the light-emitting element can be referred to as an organic light-emitting element. In this embodiment, the reflecting layer also serves as an electrode and can therefore be referred to as a reflecting electrode.

This resonator structure has a resonance peak wavelength $\lambda_{on}$ with an interference spectrum that reinforces light emitted in the direction perpendicular to the main surface of the substrate. The light emitted in the direction perpendicular to the main surface of the substrate is also referred to as light extracted in the direction perpendicular to the main surface of the substrate without the light extracting structure. In other words, the light is light emitted in the frontal direction of the substrate independently from refraction using the light extracting structure. The resonator structure has a peak wavelength $\lambda_{EL}$ of electro luminescence (EL) radiated through the light extracting structure. The wavelength $\lambda_{EL}$ is the wavelength of light emitted to front of the substrate in which optical interference due to the resonator structure and refraction due to the light extracting structure are taken into account. The PL and the PL spectrum are the behavior of the light-emitting material independent of the structure of the light-emitting element. The PL spectrum can be obtained by, for example, forming an emission layer containing the light-emitting material of an organic light-emitting element on the substrate and causing photoexcitation. The emission layer is preferably reproduced, but any solid-state membrane of a light-emitting material allows photoluminescence to be measured. In contrast, electroluminescence (EL) and an EL spectrum are luminescence characteristics in which the effects of the optical distance between the electrodes and the light extracting structure are taken into account.

The light-emitting apparatus according to this embodiment is a light-emitting apparatus in which $\lambda_{PL}$ which is a first peaks of the light-emitting material, $\lambda_{EL}$, and $\lambda_{on}$ satisfy Exp. (1). Satisfying Exp. (1) provides a light-emitting apparatus with preferable luminance in front of the substrate.

$$|\lambda_{EL} - \lambda_{PL}| < |\lambda_{on} - \lambda_{PL}| \quad (1)$$

Satisfying Exp. (1) represents that the difference between the wavelength of electroluminescence and the first peak wavelength of the light-emitting material is less than the difference between the interference peak $\lambda_{on}$ and the first peak wavelength of the light-emitting material.

The value $|\lambda_{on} - \lambda_{PL}|$ may be less than the half width at half maximum of $\lambda_{PL}$.

The light-emitting apparatus according to this embodiment has, in the resonator structure, a resonance peak wavelength $\lambda_{off}$ of an interference spectrum that reinforces light emitted in the direction perpendicular to the main surface of the substrate due to refraction in the light extracting structure. The light emitted in the frontal direction of the substrate due to the refraction with the light extracting structure is in the direction of emission from the light-emitting material, and the reflection direction at the reflecting layer is light inclined with respect to the main surface of the substrate. In Fig. 2A, emission light 12 is emitted from a point 11 where the light-emitting material emits light. The emitted light is refracted at the inclined portion 13 of the microlens 10 in the frontal direction of the substrate.

The light-emitting apparatus according to this embodiment is a light-emitting apparatus in which $\lambda_{PL}$, $\lambda_{off}$, and $\lambda_{on}$ satisfy Exp. (2). Satisfying Exp. (2) provides a light-emitting apparatus with preferable luminance in front of the substrate.

$$|\lambda_{off} - \lambda_{PL}| < |\lambda_{on} - \lambda_{PL}| \quad (2)$$

Exp. (2) represents that the difference between interference peak $\lambda_{off}$ and the first peak wavelength of the light-emitting material is less than the difference between the interference peak $\lambda_{on}$ and the first peak wavelength of the light-emitting material. In other words, the first peak wavelength of the light-emitting material is closer to the interference peak at which the light emitted in the frontal direction of the substrate is reinforced via the light extracting structure than the interference peak at which the light emitted in the substrate frontal direction is reinforced. In other words, the interference peak at which the light emitted at an angle to the substrate is reinforced is closer to the first peak of the light-emitting material. The first peak may be the maximum intensity peak in the PL spectrum of the light-emitting material in the visible range. If the PL spectrum has a second peak, the second peak may be a peak with the second highest intensity after the first peak. The light-emitting material is also referred to as luminescence dopant. The value $|\lambda_{on} - \lambda_{PL}|$ may be less than or equal to the half width at half maximum of $\lambda_{PL}$.

If the second peak is present, Exp. (3) is preferably satisfied.

$$|\lambda_{off} - \lambda_{PL}| \leq |\lambda_{on} - \lambda_{PL2}| \qquad (3)$$

where $\lambda_{PL2}$ is the wavelength of the second peak.

Exp. (3) represents that the difference between the interference peak $\lambda_{off}$ and the first peak $\lambda_{PL}$ is less than the difference between the interference peak $\lambda_{on}$ and the second peak $\lambda_{PL2}$. In other words, the interference peaks may be designed putting the first peak on a higher priority than the second peak. The first peak may coincide with $\lambda_{off}$, and the second peak may coincide with $\lambda_{on}$. Satisfying Exp. (3) is preferable because it increases the luminance in the frontal direction of the substrate. The value $|\lambda_{on} - \lambda_{PL2}|$ may be less than or equal to the half width at half maximum of the second peak.

In contrast, the light-emitting apparatus may include a second light-emitting element different from the light-emitting element, and the second light-emitting element mat be an element that does not satisfy Exp. (1). The second light-emitting element may be an element that emits light of a different color from the light-emitting element. Since the second light-emitting element is a light-emitting element that emits light of a different color, the light-emitting element does not have to satisfy both of Exp. (1) and Exp. (2). The color of light emitted from the second light-emitting element that does not satisfy Exp. (1) and Exp. (2) may be determined in accordance with the balance of red, green, and blue (RGB) of the light-emitting apparatus and may be blue, green, or red or a combination thereof.

In the light-emitting apparatus according to an embodiment of the present invention, an element that puts a higher priority on frontal luminance may satisfy (1) or (2) and (3), and an element that puts a higher priority on chromatic purity may be an element that does not satisfy (3). The element that puts a higher priority on chromatic purity does not have to satisfy (1) and (2).

The element that puts a higher priority on frontal luminance may be an element that generates green, and the element that puts a higher priority on chromatic purity may be an element that generates blue. In another embodiment, the element that puts a higher priority on frontal luminance may be an element that generates blue, and the element that puts a higher priority on chromatic purity may be an element that generates green. In yet another embodiment, the element that puts a higher priority on frontal luminance may be an element that generates red, and the element that puts a higher priority on chromatic purity may be an element that generates green or blue.

The second light-emitting element may contain a second light-emitting material different from the light-emitting material of the first light-emitting element.

The half width at half maximum of the PL spectrum of the second light-emitting material may be larger than or equal to the half width at half maximum of the PL spectrum of the light-emitting material of the first light-emitting element.

The half width at half maximum of the PL spectrum refers to the width of the first peak at an intensity of 0.5, where the PL intensity of the first peak is 1. In a light-emitting material whose spectrum widths of the first peak and the second peak are large, the minimum value of the PL intensity in the boundary between the first peak and the second peak can be greater than or equal to 0.5. In this case, the spectrum width of a spectrum obtained by adding up the spectrum components of the first peak and the second peak at an intensity of 0.5 is a half width at half maximum. If the spectrum width of the first peak is extremely large, it appears as if no second peak is present. The half width at half maximum in this case refers to the width of the entire PL spectrum at an intensity of 0.5.

The light-emitting material with an emission spectrum having the first peak and the second peak may be a fluorescence emission material or a delayed fluorescence material. The delayed fluorescence may be of a thermally activated type. In contrast, the second light-emitting material that is assumed to have a small second peak or have no second peak may be a phosphorescence emission material.

In other words, the light-emitting element containing a fluorescent material may satisfy Exp. (1) or (2) in the specification, and the second light-emitting element containing a phosphorescent material may be in a form that does not satisfy either of Exps. (1) and (2) in this specification.

The emission color of the second light-emitting element may be green. The width of the PL spectrum of the second light-emitting material may be smaller than the width of the other light-emitting elements. This is for the purpose of preventing the wavelength of green, which sandwiched between blue and red, from overlapping with the other colors.

Since the interference peak resonant wavelength $\lambda_{off}$ of the light-emitting apparatus according to this embodiment may reinforce the light of an emission angle of 15°, because light of an emission angle of 15° with respect to the substrate main surface tends to be reinforced.

To form the light-emitting apparatus according to this embodiment, specifically, the interference peak resonant wavelength in the frontal direction, which depends on the material and the thickness of the organic layer of the light-emitting element, is set closer to the long wavelength side than the PL peak wavelength of the light-emitting material. Setting the interference peak resonant wavelength closer to the long wavelength side allows the light near the PL peak wavelength with the highest intensity in the PL spectrum of the light-emitting material to be emitted toward the inclined portion of the light extracting structure. This inclined portion refracts the light in the frontal direction of the substrate, increasing the luminance in the frontal direction. The configuration of the light-emitting apparatus according to the present invention refers to an optical interference condition unique to the light-emitting element with the light extracting structure. Preferably, the inclined portion of the light extracting structure is at 0° or more and less than 90° with respect to the substrate main surface, and more preferably, at 9° or more and 60° or less. This range allows the luminance in the frontal direction of the substrate to be increased.

Reinforcing the optical interference condition refers to causing reinforcing interference by adjusting the distance $d_0$ from the light emitting position of the emission layer to the reflecting surface of the light reflective material to $d_0 = m\lambda/4n_0$ (i = 1, 3, 5, $\cdots$). This results in an increase in a component in a particular direction in the radiation distribution of light with a wavelength X, increasing the radiance at the particular angle.

The optical distance Lr between the light emitting position to the reflecting surface of the light reflecting layer, in reinforcing the wavelength $\lambda$ together, is expressed as Exp. (4).

$$\mathtt{Lr} \; = \; (2\mathtt{m} \, - \, (\phi\mathtt{r}/\pi)) \; \times \; (\lambda/4) \; \times \; 1/\cos(\Theta_{\mathtt{eml}}) \quad (4)$$

In Exp. (4), m is the order of interference between the luminous point and the reflecting layer, which is an integer greater than or equal to 0, and $n_0$ is an effective refractive index of the layer from the light emitting position to the reflecting surface at a wavelength $\lambda$. Cases where m = 0 and m = 1 in an ideal case $\Phi r = \pi$ are respectively referred to as an interference condition of $\lambda/4$ and an interference condition of $3\lambda/4$, where $\phi r$[rad] is the sum of the phase shift amounts when light with a wavelength $\lambda$ is reflected at the reflecting surface, and $\Theta_{eml}$ is an emission angle with respect to the direction of normal to the substrate in the emission layer. The optical distance Lr is the sum of the products of the refractive indices nj and the thicknesses dj of the individual layers of the organic compound layer. In other words, Lr can be expressed as $\Sigma_{nj} \times d_j$ or $n_0 \times d_0$, where $\phi$ is a negative value.

The full thickness interference L, in reinforcing the wavelength $\lambda$, is expressed as Exp. (5), where Ls is the optical distance between the light emitting position and the reflecting surface of the electrode, and $\phi s$[rad] is the sum of the phase shifts when light with a wavelength $\lambda$ is reflected at the reflecting surface of the light extracting electrode.

$$\mathtt{L} \, = \, (\mathtt{Lr} \, + \, \mathtt{Ls}) \, = \, (2\mathtt{M} \, - \, \Phi/\pi) \; \times \; (\lambda/4) \; \times \; 1/\cos(\theta_{\mathtt{eml}}) \quad (5)$$

where M is m + m', m' is the order of interference between the luminous point and the light extracting electrode, which is an integer greater than or equal to 0.

The value M is the sum of the order of interference m between the luminous point and the reflecting layer and the order of interference m' between the luminous point and the light extracting electrode (M = m + m'), which is an integer greater than or equal to 0, and $\Phi$ is the sum of the phase shifts when the light with a wavelength $\lambda$ is reflected at the light reflecting layer and the light extracting electrode ($\Phi = \phi r + \phi s$). Exp. (5) expresses interference which is referred to as the full thickness interference of the organic compound layer.

In the case of an organic light-emitting element having no inclined surface of the light extracting structure, the thickness of the organic layer is designed so that Exp. (4) and Exp. (5) are satisfied on the condition that the frontal direction $\Theta_{eml} = 0°$.

The interference peak resonant wavelength in the frontal direction, $\lambda_{on}$ (on-axis), at that time is expressed as Exp. (6) .

$$\lambda_{\mathtt{on}} \; = \; 4\pi\mathtt{L}/(2\pi\mathtt{M} \, - \, \Phi) \quad (6)$$

For an organic light-emitting element without the inclined surface of the light extracting structure, the thickness and the material are designed so that the peak resonant wavelength $\lambda_{on}$ in the frontal direction, expressed by Exp. (6), substantially coincides with the peak wavelength $\lambda_{PL}$ of the PL spectrum of the luminescence dopant.

In contrast, with the light extracting structure, in other words, according to an embodiment of the present invention, the emission angle in the frontal direction in the organic light-emitting element changes depending on the pixel light emitting position in the pixel luminous region.

Figs. 2A and 2B are diagrams illustrating the emission light 12, which is emitted from a luminous point 11 above the reflecting layer 6, refracted at the inclined portion 13 of microlens 10 into the direction normal to the substrate. In this case, the microlenses 10 are illustrated as an example of the light extracting structure 4. The direction of the light depends on the relationship between the inclination angle and the light emitting position regardless of the shape of the light extracting structure. Reference signs $n_0$, $n_1$, $n_2$, and $n_{eml}$ in Fig. 2A denote the respective refractive indices of the outside of the element, the microlens, the protecting layer, and the organic film emission layer, which show the relationship $n_0 < n_1$. Here, $n_2 = n_{eml}$ for clarity. Reference sign $n_3$ in Fig. 2B denotes the refractive index of a filler layer that fills the gap between the microlenses 10 and the protecting layer 9, which shows the relationship $n_3 < n_1$. The organic layer 7 and the protecting layer 9 may each have a laminated structure (not shown in detail in Figs. 2A and 2B), in which case, the refractive index may be a weighting average of the thicknesses, $\Sigma_{nj} \times d_j / \Sigma d_j$.

The distance X between the luminous point 11 from which the emission light 12 to be refracted in the frontal direction at the inclined portion 13 and the pixel center is expressed as Exp. (7). The emission angle $\Theta_{eml}$ of the emission light 41 in the emission layer is expressed as Exp. (8), where R is the distance between the inclined portion 13 of the microlens 10 with an angle of inclination of $\psi$ to the main surface of the substrate and the pixel center in the direction parallel to the main surface of the substrate, and r is the distance between the inclined portion 13 and the luminous point 11 in the direction parallel to the main surface of the substrate. In this case, the pixel center may be a middle point in a cross section of the lower electrode perpendicular to the substrate main surface. If the lower electrode has an insulating layer at the ends, the pixel center may be a middle point of an opening of the insulating layer on the lower electrode in a cross section perpendicular to the substrate main surface.

[Math 1]

$$X(\phi) = R(\phi) - r(\phi) = R(\phi) - \Sigma_i d_i \tan\left[\sin^{-1}\left(\frac{n_{eml}}{n_i} \sin(\theta_{eml}(\psi))\right)\right] \quad (7)$$

$$\theta_{eml}(\phi) = \sin^{-1}\left[\frac{n_i}{n_{eml}}\sin\left\{\phi - \sin^{-1}\left(\frac{n_0}{n_{eml}}\sin\psi\right)\right\}\right] \quad (8)$$

The values $d_i$ and $n_i$ are the thickness and the refractive index of the i-th layer, respectively. R($\psi$) denotes a structural parameter indicating the relationship between the position and the angle of inclination of the light extracting structure. In the case of the spherical microlenses illustrated in Fig. 2A, R = A*sin$\psi$, where A is the radius of curvature of the microlens. The values X and $\Theta_{eml}$ are functions of the angle of inclination $\psi$ of the inclined portion of the light extracting structure. In other words, the pixel luminous region responsible for the radiance in the frontal direction and the emission angle of light refracted in the frontal direction in the emission layer at the inclined surface are determined by each of the angles of inclination of the inclined portion of the light extracting structure. In other words, for the organic light-emitting element with the light extracting structure, the interference condition should be optimized for the angle of inclination with the highest contributing rate among the inclined portions constituting the light extracting structure. Specifically, the difference between the interference peak resonant wavelength at an emission angle $\Theta_{eml}$ corresponding to the angle of inclination with the highest contributing rate and the PL peak wavelength is decreased.

Next, the inclined portion with the highest contributing rate is defined, and the interference peak resonant wavelength in the direction of the emission angle $\Theta_{eml}$ corresponding to the inclination angle with the highest contributing rate will be described. The inclined portion with the highest contributing rate refers to an inclined portion with the maximum luminous area of a pixel emission range in which light refracted in the frontal direction at the inclined portion of the light extracting structure can be emitted.

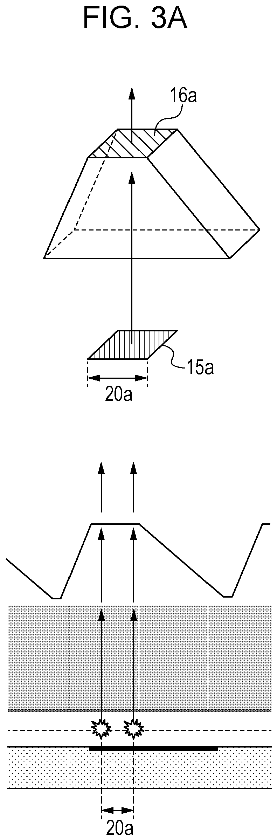

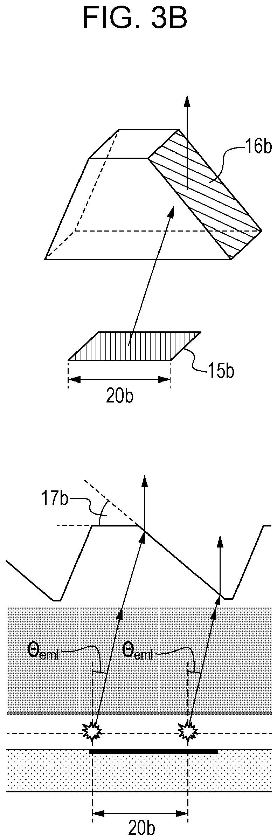

Figs. 3A and 3B are diagrams illustrating the light extracting structure according to this embodiment, extracting light in the frontal direction of the light-emitting apparatus. Fig. 3A is a schematic diagram illustrating light emitted from a luminous point in the frontal direction of the light-emitting apparatus. Fig. 3B is a schematic diagram illustrating light emitted from the luminous point in a direction inclined with respect to the substrate main surface. Fig. 3A is a solid figure illustrating the relationship between a luminous area 15a and a light extracting surface 16a, in which the lower part is a cross-sectional view perpendicular to the substrate main surface including a pixel center. Fig. 3A illustrates the light extracting surface 16a (an inclination angle of 0°) from which light is emitted in front of the substrate main surface due to the optical interference in the frontal direction of the organic light-emitting element, the luminous area 15a corresponding to it, and a luminous region 20a that emits light in the frontal direction. Fig. 3B illustrates a luminous area 15b that can emit light refracted in the frontal direction at an inclined portion 16b (an inclination angle 17b) of a trapezoid and a luminous region 20b that can emit light refracted in the frontal direction. In the case of the light extracting structure of the trapezoid illustrated in Figs. 3A and 3B, a pixel area 15b is the largest. In this embodiment, the light extracting structure has inclined portions. However, any shape may be employed that allows light at an angle with respect to the substrate main surface to be refracted in the frontal direction of the substrate.

Here, the emission angle $\Theta_{eml}$ corresponding to the inclined portion with the highest contributing rate is an emission angle at a luminous point of light emitted from the maximum luminous area, described above, and refracted in the frontal direction at the inclined portion with the highest contributing rate.

In Fig. 3B, $\Theta_{eml}$ is the emission angle of light emitted from the largest pixel area 16a and refracted in the frontal direction via the inclined portion 16b. The interference peak resonant wavelength $\lambda_{off}$ (off-axis) at an angle of $\Theta_{eml}$ with respect to the main surface of the substrate is expressed by Exp. (9). The sign $\lambda_{off}$ is hereinafter also referred to as an interference peak resonant wavelength in an oblique direction.

$$\lambda_{off} = 4\pi L/(2\pi M - \Phi) \times 1/\cos(\Theta_{eml}) \qquad (9)$$

It is preferable to determine an optical interference condition for the organic light-emitting element so that the difference between the interference peak resonant wavelength $\lambda_{off}$ in Exp. (9) and the PL peak wavelength $\lambda_{PL}$ of the light-emitting material is smaller than the difference between the interference peak wavelength $\lambda_{on}$ in the frontal direction defined by Exp. (9) and $\lambda_{PL}$. The interference peak resonant wavelength $\lambda_{off}$ may be almost equal to the peak wavelength $\lambda_{EL}$ of the EL spectrum of the light-emitting apparatus of this embodiment, which will be illustrated in the examples. In other words, the optical interference condition of the organic light-emitting element may be determined so that the difference between $\lambda_{EL}$ and $\lambda_{PL}$ is smaller than the difference between the interference peak wavelength $\lambda_{on}$ in the frontal direction and $\lambda_{PL}$.

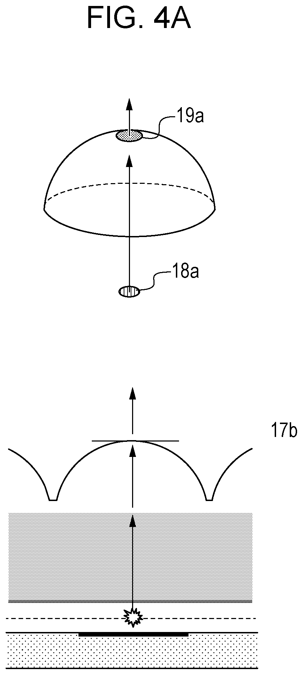

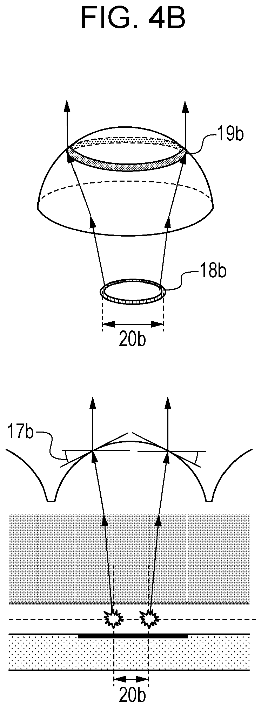

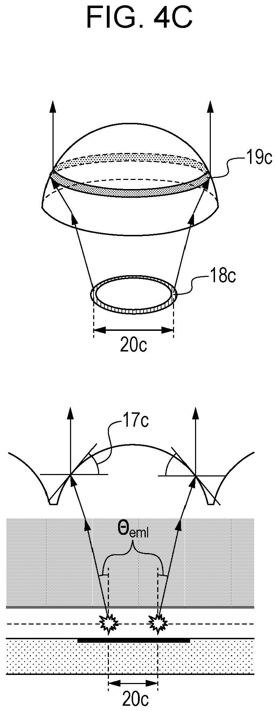

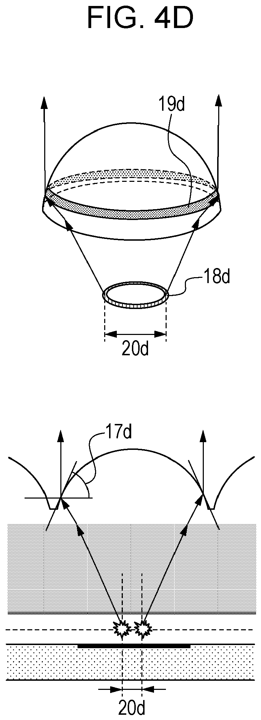

Figs. 4A to 4D are schematic diagrams illustrating a method for estimating a preferable emission angle $\Theta_{eml}$ using a spherical microlens as an example of the light extracting structure. Figs. 4A to 4D differ from each other in the angle of light with respect to the substrate main surface. The upper parts are solid figures illustrating the relationship between luminous areas 18a to 18d and a light extracting surface 19a and inclined portions 19b to 19d, respectively. The lower parts including the pixel center are cross-sectional views perpendicular to the substrate main surface including the pixel center. Reference sign 19a denotes a light extracting surface because it is not inclined. Reference signs 19b to 19d denote inclined portions because they are inclined, which are also referred to as "light extracting surfaces". In the microlenses illustrated in Figs. 4A to 4D as well, the inclined portion with the highest contributing rate is an inclined portion with the largest luminous area of the pixel luminous range capable of emitting light that is refracted in the frontal direction at the inclined portion of the light extracting structure. In other words, in the case of the spherical microlens, the position where the luminous area is the largest corresponds to the outermost peripheral region. Fig. 4C illustrates a state in which light emitted from the largest luminous region 18c of the luminous region at which light can be refracted in the frontal direction at the inclined surface of the spherical microlens is refracted to front at the inclined portion 19c. In the case of microlenses, $\Theta_{eml}$ is set as the emission angle in the emission layer from the outermost peripheral region 18c to the inclined portion 19c, as shown in Fig. 4C. A ray-trace simulation shows that the emission angle $\Theta_{eml}$ is preferably larger than 0° and less than 30° and, more preferably, 5° or more and 20° or less.

Next, the effect of the difference between the interference peak resonant wavelength $\lambda_{off}$ in an oblique direction in Exp. (9) and the PL peak wavelength $\lambda_{PL}$ of the light-emitting material being smaller than the difference between the interference peak wavelength $\lambda_{on}$ in the frontal direction defined by Exp. (6) and $\lambda_{PL}$ will be described.

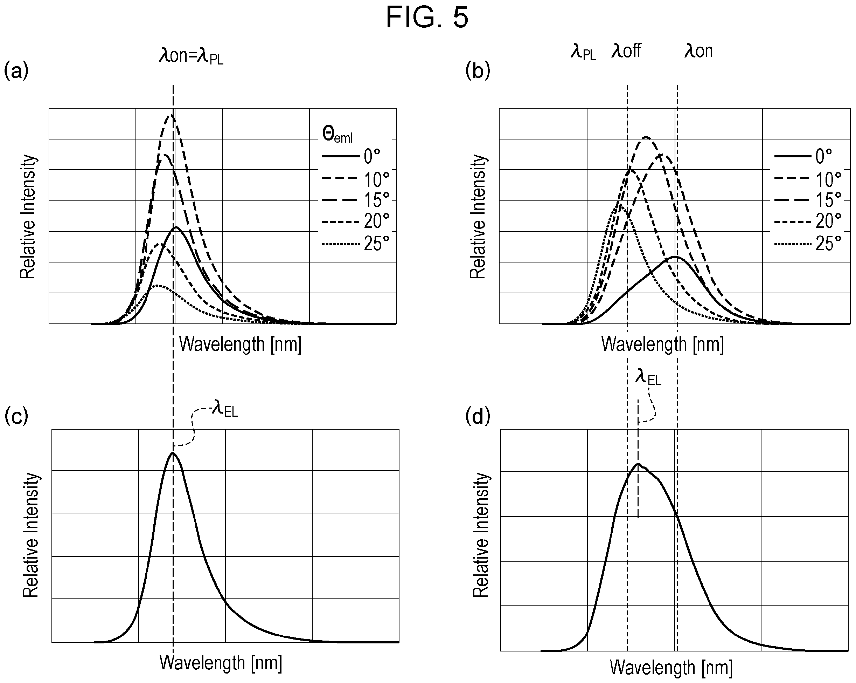

Fig. 5 shows graphs of the PL spectrum of a light-emitting material, an interference spectrum reinforcing light in the frontal direction, and an interference spectrum reinforcing light in an oblique direction. Fig. 5(a) shows the relationship among $\lambda_{off}$, $\lambda_{on}$, and $\lambda_{PL}$ in a light-emitting element with a conventional configuration for reinforcing the light emitted in the frontal direction of the substrate main surface together. Fig. 5(b) shows the configuration of the light-emitting element according to the present invention for reinforcing the light emitted in a direction inclined with respect to the substrate main surface together. The configuration in Fig. 5(b) shows a case in which the difference between the interference peak resonant wavelength $\lambda_{off}$ in a direction inclined with respect to the substrate main surface and the PL peak wavelength $\lambda_{PL}$ of the light-emitting material is smaller than the difference between the interference peak $\lambda_{on}$ in the frontal direction of the substrate main surface and $\lambda_{PL}$. Fig. 5(c) shows a spectrum in the frontal direction through the microlens of the light-emitting element with the configuration of (a). Fig. 5(d) shows a spectrum in the frontal direction through the microlens of the light-emitting element with the configuration of (b). Figs. 5(a) and (b) are graphs of the spectrums in (c) and (d) exploded for the individual emission angle components in the emission layer, respectively.

Fig. 5 assumes the microlenses as illustrated in Figs. 4A to 4D, in which $\Theta_{eml}$ is about 15°. However, this effect does not depend on the value of $\Theta_{eml}$.

The value $\Theta_{eml} = 0°$ in Figs. 5(a) and(b) corresponds to the emission intensity of the light-emitting element without the light extracting structure in the configurations of the individual light-emitting elements. In the case of the organic light-emitting element without the light extracting structure, as described above, the interference peak wavelength $\lambda_{on}$ in the frontal direction and $\lambda_{PL}$ are made to coincide. This can be seen from the fact that the radiance at $\Theta_{eml} = 0°$ in Fig. 5(a) is higher than the radiance at $\Theta_{eml} = 0°$ in Fig. 5(b). In contrast, with the microlens, the contributing rate of $\Theta_{eml}$ to the radiance in the frontal direction changes. In other words, the light refracted in the frontal direction varies with the angle.

With the conventional configuration in Fig. 5(a), the interference peak resonant wavelength $\lambda_{off}$ with the efficiency of extraction in the frontal direction (hereinafter, referred to as front extraction efficiency) with the light extracting structure is located closer to the short-wavelength side than the PL spectrum $\lambda_{PL}$. The PL spectrum decreases steeply on the short-wavelength side of the PL peak. In other words, the intensity decreases significantly. This causes the spectrum area (radiance) on the short-wavelength side of the PL peak wavelength to decrease. For this reason, in the wavelength area of $\lambda_{off}$ in Fig. 5(a), the effect of reinforcing $\lambda$ off together is large, but the increase in frontal-light extraction efficiency due to the light extracting structure is small because the amount of light emitted from the light-emitting material is small. This is also shown by the low emission intensity of $\Theta_{eml} = 15°$, $25°$ in Fig. 5(a) .

In contrast, in the case where the difference between the interference peak resonant wavelength $\lambda_{off}$ in a direction inclined with respect to the substrate main surface and the PL peak wavelength $\lambda_{PL}$ is smaller than the difference between the interference peak wavelength $\lambda_{on}$ in the frontal direction of the substrate main surface and $\lambda_{PL}$, the region with high frontal-light extraction efficiency of the light extracting structure and the region with a high emission intensity of the PL spectrum coincide. In other words, the radiance of $\Theta_{eml} = 15°$, $25°$ in Fig. 5(b) can be increased. Since the spectrum area in Fig. 5(d) is larger than the spectrum area in Fig. 5(c), the light-emitting element in Fig. 5(d) has a higher radiance of the organic light-emitting element with the light extracting structure. In other words, the radiance in the frontal direction is higher when the difference between the interference peak resonant wavelength $\lambda_{off}$ in a direction inclined with respect to the substrate main surface and the PL peak wavelength $\lambda_{PL}$ is smaller than the difference between the interference peak wavelength $\lambda_{on}$ in the frontal direction of the substrate main surface and $\lambda_{PL}$.

Since the present invention is configured so that the interference peak wavelength $\lambda_{on}$ in front of the substrate main surface of the organic light-emitting element with the light extracting structure is closer to the long wavelength side with respect to the PL peak wavelength $\lambda_{PL}$ of the light-emitting material, the frontal radiance is high. In other words, setting the difference between the interference peak resonant wavelength $\lambda_{off}$ in a direction inclined with respect to the substrate main surface and the PL peak wavelength $\lambda_{PL}$ smaller than the difference between the interference peak wavelength $\lambda_{on}$ in the frontal direction and $\lambda_{PL}$ remarkably increases the frontal radiance. As shown in Figs. 5(b) and (d), the interference peak resonant wavelength $\lambda_{off}$ in a direction inclined with respect to the substrate main surface and the peak wavelength $\lambda_{EL}$ of the EL spectrum almost coincide.

To increase the radiance in the frontal direction of the substrate main surface, $\lambda_{off}$ and $\lambda_{PL}$ may be made to coincide. When the spectrum of the light-emitting material has the second peak $\lambda_{PL2}$ with lower intensity than $\lambda_{PL}$, $\lambda_{PL2}$ may be made to coincide with $\lambda_{on}$. In other words, the interference spectrum in a direction inclined with respect to the substrate main surface is close to $\lambda_{PL}$, and the interference spectrum in the frontal direction of the substrate main surface is close to $X_{PL2}$. In comparison of them, $\lambda_{PL}$ and $\lambda_{off}$ may be closer to each other than $\lambda_{PL2}$ and $\lambda_{on}$.

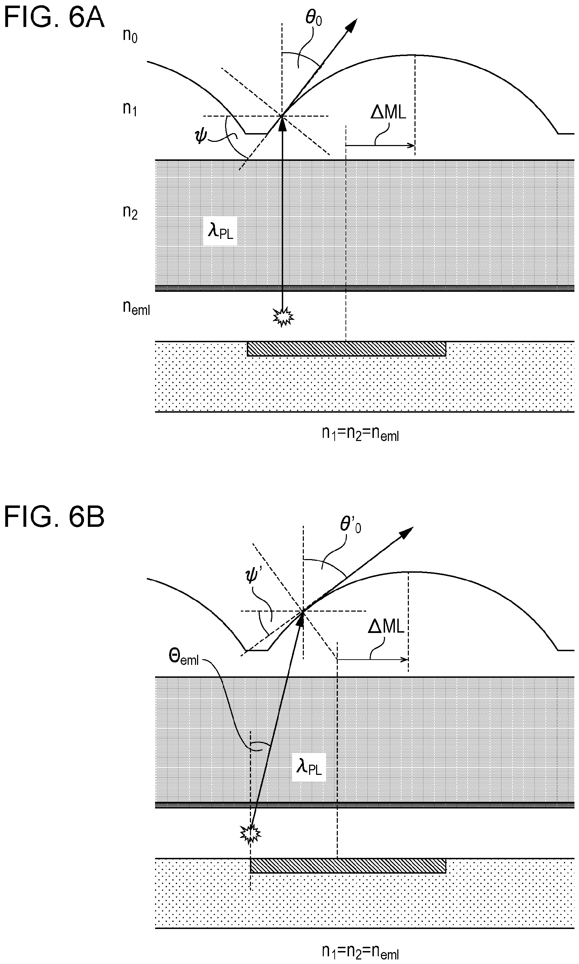

Figs. 6A and 6B are schematic diagrams illustrating emission light refracted by the shifted microlens. Since the interference peak resonant wavelength $\lambda_{off}$ in a direction inclined with respect to the substrate main surface is close to the PL peak wavelength $\lambda_{PL}$, the light with the PL peak wavelength can be refracted to the wide-angle side by shifting the microlens. The shifting of the microlens (hereinafter, $\Delta$ML) means providing a distance between the central position of the microlens and the central position of the pixel opening in the direction parallel to the substrate main surface. The center of the microlens can be estimated from the middle point of the microlens in a cross section perpendicular to the substrate main surface. The center of the pixel opening can be estimated from the middle point of the lower electrode in a cross section perpendicular to the substrate main surface. If the ends of the lower electrode are covered with a pixel separating layer, the center of the pixel opening can be estimated using the middle point of a line segment from the pixel separating layer to the pixel separating layer in the cross-sectional view. These cross-sectional views may be selected so as to pass through the apex of the microlens.

In this embodiment, the optical distance may be roughly estimated, with the refractive index of the organic layer assumed to be 1.9. In this case, a constant A that satisfies Exp. (A) is provided.

$$1.9D < A\lambda_{PL}/4 < 1.9D/\cos\theta \quad (A)$$

where $\lambda_{PL}$ is the emission wavelength of the light-emitting material, D is the interelectrode distance, and $\theta$ is the inclination angle of the emission light.

The value $A\lambda_{PL}/4$ may be closer to $1.9D/\cos\theta$ than to $1.9D$. In other words, the interference spectrum inclined at an angle of $\theta$ contributes more to the interference of the emission wavelength $\lambda_{PL}$ of the light-emitting material than the interference spectrum in the frontal direction of the substrate.

The light-emitting apparatus according to this embodiment may include a second light-emitting element different from the light-emitting element and a second light extracting structure that is different from the light extracting structure and that receives light from the second light-emitting element, in which the distance in the direction parallel to the substrate main surface between the middle point of the luminous region of the light-emitting element and the middle point of the light extracting structure in a cross section perpendicular to the substrate main surface may be smaller than the distance in the direction parallel to the substrate main surface between the middle point of the luminous region of the second light-emitting element and the middle point of the second light extracting structure in a cross section perpendicular to the substrate main surface.

The light-emitting apparatus according to this embodiment may further include a third light-emitting element different from the second light-emitting element and a third light extracting structure that is different from the second light extracting structure and that receives light from the third light-emitting element, in which the distance in the direction parallel to the substrate main surface between the middle point of the luminous region of the second light-emitting element and the middle point of the second light extracting structure in a cross section perpendicular to the substrate main surface may be smaller than the distance in the direction parallel to the substrate main surface between the middle point of the luminous region of the third light-emitting element and the middle point of the third light extracting structure in a cross section perpendicular to the substrate main surface.

Fig. 6A illustrates a conventional configuration in which the interference peak resonant wavelength $\lambda_{on}$ in the frontal direction of the substrate main surface and $\lambda_{PL}$ are made to coincide. Fig. 6B illustrates a configuration in which the interference peak resonant wavelength $\lambda_{off}$ in a direction inclined with respect to the substrate main surface and $\lambda_{PL}$ are made to coincide. With the configuration in Fig. 6B, the light with the PL peak wavelength $\lambda_{PL}$ is emitted at wider angles than with the configuration in Fig. 6A because of the shift of the microlens. This is because the configuration in Fig. 6B causes interference that reinforces light in a direction inclined with respect to the substrate main surface. Here, $n_1 = n_2 = n_{eml}$, and $n_0 < n_1$ are set for clarity. Even if the light is refracted at the individual interfaces, the configuration in Fig. 6B causes the light of $\lambda_{PL}$ to be emitted at wider angles than in Fig. 6A.

In Figs. 6A and 6B, light is emitted from the luminous region and is refracted at an angle of $\theta_0$ ($\theta'_0$ in Fig. 6B) by the inclined portion of the microlens. A condition for Fig. 6A is expressed as Exp. (10).

$$n_0 \times \sin(\theta_0 + \psi) = n_{eml} \times \sin(\theta_{eml} + \psi) \quad (10)$$

where $\psi$ ($\psi'$ in Fig. 6B) is the inclination angle of the microlens.

The sign $\Theta_{eml}$ denotes the emission angle at the luminous point. In Fig. 6A in which $\lambda_{on} = \lambda_{PL}$, $\Theta_{eml} = 0°$ holds, and in Fig. 6B in which $\lambda_{off} = \lambda_{PL}$, $\Theta_{eml} = \Theta_{eml}$ holds. As is shown in Figs. 6A and 6B and Exp. (10), the light-emitting apparatus according to the present invention emits light with $\lambda_{PL}$ in a direction inclined with respect to the inclined portion, as shown in Fig. 6B, the light with $\lambda_{PL}$ can be refracted at wider angles. The maximum value of the refracting angle derived from the total reflection condition of Exp. (10) is expressed as Exp. (11) for $\lambda_{on} = \lambda_{PL}$ and Exp. (12) for $\lambda_{off} = \lambda_{PL}$.

$$\theta_0 = \pi/2 - \sin^{-1}(n_0/n_{eml}) \quad (11)$$

$$\theta_0' = \pi/2 + \theta_{eml} - \sin^{-1}(n_0/n_{eml}) = \theta_0 + \Theta_{eml} \quad (12)$$

In other words, the refracting direction can be shifted to the wider angle by $\Theta_{eml}$ than with the conventional configuration with the optical interference condition for the organic light-emitting element for bringing the interference peak resonant wavelength $\lambda_{off}$ in a direction inclined with respect to the substrate main surface close to the PL peak wavelength $\lambda_{PL}$. In other words, the configuration of this embodiment can increase the angle adjustment range by shifting the microlens as compared with the conventional configuration. The wider angle emission allows application to a shorter focus optical part with a small display while increasing the field of view (FOV). In other words, for example, a head mount display can be reduced in size.

The distance in a substrate in-plane direction between the central position of the light extracting structure and the central position of the pixel opening may be adjusted as appropriate in at least some regions of the light-emitting apparatus.

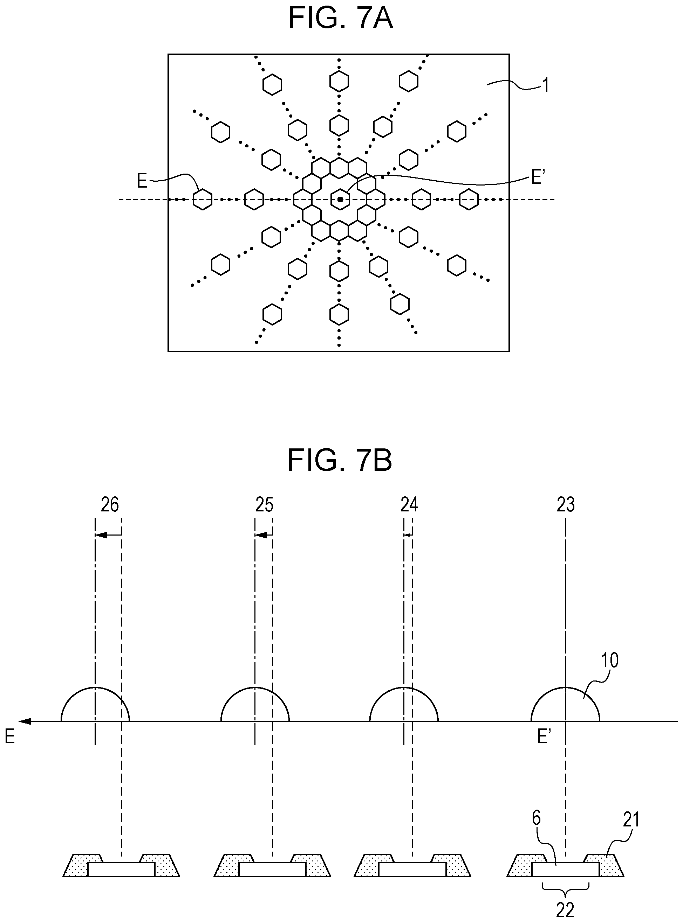

Figs. 7A and 7B are plan views illustrating the relative position of the microlenses and the pixels vary with the position in the display area. Fig. 7A is a plan view of the display area. Fig. 7B is a schematic cross-sectional view taken along line E-E' in Fig. 7A. Fig. 7B illustrates the relationship between the relative position of the center of the microlens 10 and the center of a luminous region 22 and the position of the light-emitting element in the display area. At the central position of the display area 1, the center of the microlens and the center of the luminous region coincide. In other words, $\Delta$ML 23 is 0. The closer to the left in the drawing, the larger the distance between the center of the microlens and the center of the luminous region. In other words, $\Delta$ML 24 is larger than $\Delta$ML23, and $\Delta$ML 25 is larger than $\Delta$ML 24. In Fig. 7B, $\Delta$ML 26 is the largest distance between the center of the microlens and the center of the luminous region. The distance between the center of the microlens and the center of the luminous region in the drawing is illustrative only.

The distance ∆ML may increase from the center to the end of the display area or, alternatively, may decrease from the center to the end of the display area. The distance ∆ML may be changed continuously in a broad view with respect to the position in the display area. The distance ∆ML may be changed in any way in a broad view, for example, for each light-emitting element or stepwise every multiple light-emitting elements. Alternatively, the configuration in which the distance ∆ML is changed for each light-emitting element and the configuration in which ∆ML is changed stepwise every multiple light-emitting elements may be combined. In this embodiment, ∆ML 23 at the center of the display area is 0 but does not have to be 0. The distance ∆ML in the display area may be fixed.

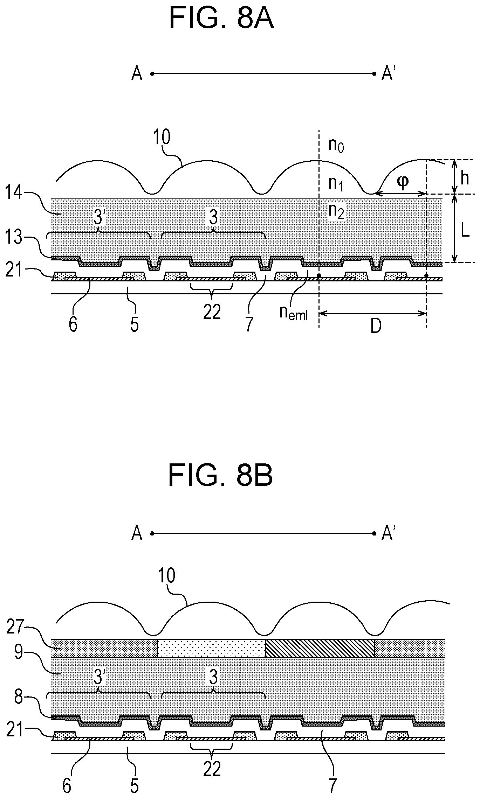

Figs. 8A to 8D are diagrams illustrating other configuration examples of the light-emitting apparatus according to an embodiment of the present invention. Fig. 8A is a schematic cross-sectional view of a light-emitting apparatus according to an embodiment of the present invention. In this embodiment, the light extracting structure is microlenses as an example. The light extracting structure may be any structure having an inclination angle with respect to the main surface of the insulating layer and may be, in addition to the microlenses, aspherical microlenses, conical, columnar, or digital microlenses.

Fig. 8A illustrates a light-emitting apparatus in which the light-emitting element 3 on the substrate 5 includes the reflecting layer 6, a pixel separating layer 21 covering the ends of the reflecting layer, the organic layer 7 containing a light-emitting material, the transflective electrode 8, the protecting layer 9, and the microlenses 10. A portion of the reflecting layer 6 not covered with the pixel separating layer 21 is the luminous region 22. The portion of the reflecting layer 6 not covered with the pixel separating layer 21 is also referred to as a pixel opening. The pixel separating layer 21 has a structure called a bank and serves as an insulating layer. The reflecting layer 6 and the transflective electrode 8 are also referred to as a lower electrode and an upper electrode, respectively, from the placement positions. Dummy pixels 3' are disposed outside the display area 1 to maintain the properties of the outermost light-emitting element. The dummy pixels 3' may be provided in multiple columns and multiple rows. The components of the dummy pixels may be the same as the components of the light-emitting elements. The dummy pixels may have the same configuration as the light-emitting elements except that no current is supplied thereto.

An insulating layer (not shown) may be provided on the substrate 5. The insulating layer may be formed of, for example, an oxide layer, a nitride layer, or an organic layer. The insulating layer is also referred to as a planarizing layer because of its function. For example, the insulating layer may have the function of reducing the effect of the surface irregularities of the transistors formed on the substrate exerted on the electrodes.

The organic layer 7 may be constituted by a plurality of layers. The plurality of layers includes an emission layer, which contains a light-emitting material. An emission layer that emits light of a single color may be formed on the light-emitting elements and over the entire surface between the light-emitting elements. Alternatively, emission layers that emit light of different colors may be layered on the light-emitting elements and over the entire surface between the light-emitting elements so that the display apparatus can display at least two colors, or an emission layer that emits different colors of light for each light-emitting element may be patterned. If the organic layer is made of an emission layer that emits white light, a color filter may be provided between the light-emitting elements and the microlenses.

The protecting layer 9 is a layer for protecting the light-emitting elements and may be an inorganic layer, such as silicon nitride, silicon oxynitride, silicon oxide, or aluminum oxide, or an organic layer, such as an acrylate resin, an epoxy resin, or a polyimide resin.

The microlenses 10 receives light emitted from the light-emitting elements. A planarizing layer (not shown) may be provided between the microlenses and the protecting layer. The planarizing layer may also serve as an adhesion layer. The planarizing layer may be made of the same resin as the microlenses.

Fig. 8A illustrates the distance L from the transflective electrode 8 to the microlens, the height h of the microlens, the radius φ of the microlens, the distance D between the apex of the microlens and the apex of the neighboring microlens, the refractive index $n_2$ of the protecting layer, the refractive index $n_1$ of the microlens, and the external refractive index $n_0$. The distance D does not have to be fixed. More specifically, the distance D may be increased with a decreasing distance to the end of the display area, or the distance D may be increased with a decreasing distance to the end of the display area. In this embodiment, the height is a distance in the vertical direction of the plane of the drawing.

Fig. 8B is a schematic cross-sectional view of a light-emitting apparatus further including a color filter. A color filter 27 is further provided between the protecting layer 9 and the microlenses 10. The color filter transmits a specific wavelength. For example, the color filter may allow red (R) of RGB to pass through. As shown in Fig. 8B, three kinds of color filters that individually transmit RGB may be provided.

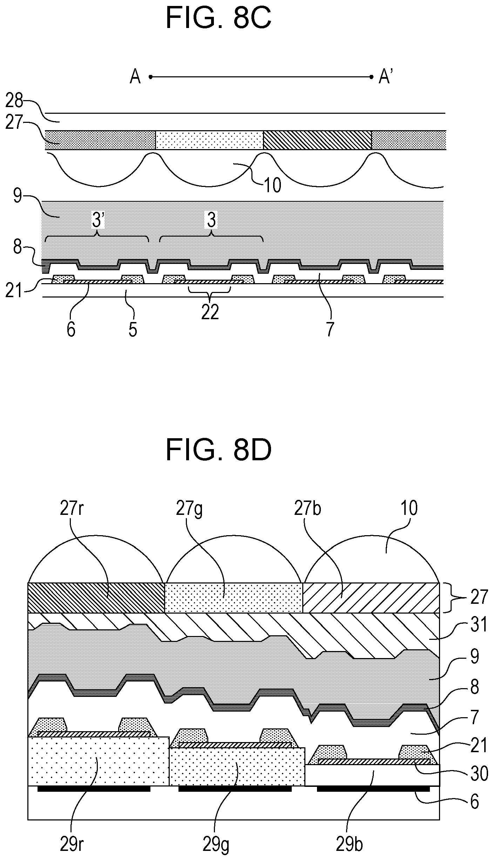

Fig. 8C is a schematic cross-sectional view of a light-emitting apparatus with a color filter and microlenses with a different configuration. The microlenses 10' differ from other embodiments and are convex downward in the plane of the drawing. In other words, downward in the plane of the drawing is the direction from the transflective electrode to the reflecting layer. The gap between the microlenses 10' and the protecting layer 9 may be void or filled with another substance. A resin layer may be provided between the color filter 27 and the microlenses 10'.

A protective glass 28 is provided on the color filter 27. An organic layer, such as an adhesion layer, may be disposed between the protective glass 28 and the color filter 27. The protective glass 28 is located at a position opposite to the substrate 5 and is therefore also referred to as an opposing substrate because of its placement position.

Fig. 8D is a schematic cross-sectional view of a light-emitting apparatus in which the optical interference distance of the light-emitting element varies among emission colors. An optical adjustment layer 29, a transparent electrode 30, an organic layer 7, a transflective electrode 8, a protecting layer 9, a filling layer 31, a color filter 27, and microlenses 10 are disposed above the reflecting layer 6. The color filter 27 is denoted by 27R, 27G, or 27B in accordance with the transmission color, which is a red filter, a green filter, or a blue filter. The optical distance between the reflecting layer 6 and the transflective electrode 8 varies with the thickness of the optical adjustment layer 29. A light-emitting element that reinforces blue, a light-emitting element that reinforces green, and a light-emitting element that reinforces red are arranged in order from the right in the drawing. The thickness of the optical adjustment layer of the first light-emitting element is larger than the thickness of the optical adjustment layer of the second light-emitting element. This configuration allows an optimum optical interference distance for the individual emission colors to be provided. In this embodiment, the optical interference distance is changed among colors using the optical adjustment layer under the transparent electrode. Alternatively, the optical adjustment layer may be disposed on the transflective electrode. The optical interference distance for each light-emitting element can be optimized by changing the thickness of the organic layer for each light-emitting element. If the thickness of the organic layer is changed for each light-emitting element, preferably, the thickness of the organic layer adjacent to the reflecting layer with respect to the emission layer is changed.

The region of wavelengths transmitted by the color filter may include the PL peak wavelength of the light-emitting material. When priority is given to the luminance of the light-emitting apparatus in the case where the PL peak of the light-emitting material includes a first peak and a second peak lower than the first peak, the first peak wavelength and the second peak wavelength may be included in the region of wavelengths transmitted by the color filter. When priority is given to the chromatic purity of the light-emitting apparatus in the case where the PL peak of the light-emitting material includes the first peak and the second peak lower than the first peak, only the first peak may be included in the region of wavelengths transmitted by the color filter.

This is preferable in application to devices that place importance on the luminance, for example, a head mount display and an augmented reality (AR) glass.

In this embodiment, the light-emitting element may include an electrode that supplies an electric charge to the light-emitting material and a pixel separating layer that covers one end and the other end of the electrode. The pixel separating layer may also be referred to as an insulating layer on the lower electrode. The insulating layer here is another layer different from the insulating layer under the lower electrode. The pixel separating layer is also referred to as a bank.

The middle point of the light extracting structure in the direction parallel to the main surface of the insulating layer and the middle point between one end and the other end of the pixel separating layer do not have to be superposed on each other in plan view in a cross section perpendicular to the main surface of the substrate.

The light-emitting apparatus includes a display area. The display area includes a first area including the central portion of the display area and a second area outside the first area in plan view.

The first area includes a third light-emitting element, and the second area includes a fourth light-emitting element. The distance between the middle point of the light extracting structure and the middle point between one end and the other end of the pixel separating layer of the fourth light-emitting element is larger than the distance between the middle point of the light extracting structure and the middle point between one end and the other end of the pixel separating layer of the third light-emitting element. In other words, the gap between the light extracting structure and the bank opening of the fourth light-emitting element is larger.

[Configuration of Light-Emitting Element]

The light-emitting element includes an insulating layer, a first electrode, an organic compound layer, and a second electrode on a substrate. For example, a protecting layer, a color filter, and microlenses may be provided above the negative electrode. If a color filter is provided, a planarizing layer may be provided between the color filter and the protecting layer. The planarizing layer may be made of an acrylic resin or the like. This also applies to a planarizing layer provided between the color filter and the microlenses.

[Substrate]

The substrate is made of quartz, glass, a silicon wafer, resin, metal, or the like. Switching elements, such as transistors, and wiring lines may be provided on the substrate, on which an insulating layer may be provided. The insulating layer may be made of any material that allows contact holes to be formed therein so that wiring lines can be formed between the insulating layer and the first electrode and that ensures insulation from unconnected wiring lines. Examples include resins, such as polyimide, silicon oxide, and silicon nitride.

[Light-Emitting Element]

The light-emitting element includes a first electrode, a second electrode, and an emission layer disposed between the first electrode and the second electrode and containing a light-emitting material. The emission layer may be either an organic compound layer or an inorganic compound layer. The electrode may also serve as a reflecting layer. The light-emitting material may be either a fluorescence emitting material or a phosphorescence emitting material.

[Electrodes]

The electrodes may be a pair of electrodes. The pair of electrodes may include a positive electrode and a negative electrode. When an electric field is applied in the direction in which the organic light-emitting element emits light, an electrode with a high potential is the positive electrode, and the other is the negative electrode. In other words, an electrode that supplies holes to the emission layer is the positive electrode, and an electrode that supplies electrons is the negative electrode. The electrodes may be formed across a plurality of light-emitting elements or separately formed for each light-emitting element. For example, the positive electrode may be separately formed for each light-emitting element, and the negative electrode may be formed across a plurality of light-emitting elements.

Preferably, a material for the positive electrode has the largest possible work function. Examples include single metals, such as gold, platinum, silver, copper, nickel, palladium, cobalt, selenium, vanadium, tungsten, and silicon, a mixture thereof, an alloy thereof, and metal oxides, such as tin oxide, zinc oxide, indium oxide, indium tin oxide (ITO), and indium zinc oxide. Other examples include conductive polymers, such as polyaniline, polypyrrole, and polythiophene.

These electrode materials may be used alone or in combination of two or more materials. The positive electrode may be formed of one layer or a plurality of layers.

For use as a reflecting layer, chromium, aluminum, silver, titanium, tungsten, molybdenum, an alloy thereof, or a laminate thereof may be used. A reflecting layer not having the function of an electrode may be made of the above materials. Examples for use as a transparent electrode include, but are not limited to, oxide transparent conductive layers made of indium tin oxide (ITO) or indium zinc oxide. The electrodes may be formed using a photolithography technique. The reflecting layer preferably has a reflectance of 70% or more at an emission wavelength. The reflecting layer may also serve as an electrode.

In contrast, a material for the negative electrode preferably has a small work function. Examples include alkali metal, such as lithium, alkali earth metal, such as calcium, single metals, such as aluminum, titanium, manganese, silver, lead, and chromium, and a mixture thereof. Other examples include alloys of such single metals. Examples include a magnesium-silver alloy, an aluminum-lithium alloy, an aluminum-magnesium alloy, a silver-copper alloy, and a zinc-silver alloy. Metal oxide, such as indium tin oxide (ITO), may also be used. These electrode materials may be used alone or in combination of two or more materials. The negative electrode may be formed of one layer or multiple layers. Among them, silver is preferably used, and more preferably, a silver alloy is used to reduce silver agglomeration. Any alloy ratio that reduces silver agglomeration is possible. For example, the ratio of silver to another meal may be 1 : 1 or 3 : 1.

Examples of the negative electrode include, but are not limited to, a top emission element made of an oxide conductive layer, such as ITO, and a bottom emission element made of a reflecting layer, such as aluminum (Al). Examples of a method for forming the negative include, but are not limited to, direct-current sputtering and alternate-current sputtering, which more preferably provide large film coverage, enhancing ease of decreasing the resistance.

For use as a transflective electrode, metal that transmits part of incident light and reflects part of the incident light is used. A sufficiently thin metal layer may be used as the transflective electrode. For example, silver about 10 nm thick may be used as the transflective electrode.

[Organic Layer]

The organic layer may be formed of one layer or multiple layers. The organic layer, if including multiple layers, may be referred to as a hole injection layer, a hole transport layer, an electron blocking layer, an emission layer, a hole blocking layer, an electron transport layer, an electron injection layer, or a charge generating layer depending on the function. The organic layer is mainly composed of an organic compound but may contain inorganic atoms or an inorganic compound containing, for example, copper, lithium, magnesium, aluminum, iridium, platinum, molybdenum, or zinc.

The organic layer may include multiple emission layers. Any of the emission layers may contain a red emitting material, a green emitting material, or a blue emitting material. Mixing the emitting materials allows emission of white light. Any of the emission layers may contain complementary color emitting materials, such as a blue emitting material and a yellow emitting material. The emitting material may be a fluorescent material, a phosphorescent material, a delayed fluorescence material, or CdS or perovskite quantum dots. Light of different colors may be emitted by changing the material or the configuration of the emission layer for each light-emitting element. The emission layer may be formed for each light-emitting element. The organic compound layer may be disposed between the first electrode and the second electrode and may be disposed in contact with the first electrode and the second electrode.

[Protecting Layer]

The protecting layer is an insulating layer and preferably contains a translucent inorganic material with low permeability of oxygen and moisture from the outside. The protecting layer can be formed of an inorganic material, such as silicon nitride (SiN), silicon oxynitride (SiON), silicon oxide (SiOx), aluminum oxide ($Al_2O_3$), or titanium oxide ($TiO_2$). The protecting layer may be provided directly on the negative electrode or with an organic resin layer disposed therebetween. The organic resin layer may be made of, for example, polyacrylate, polyimide, polyester, or epoxy.

Bonding glass with absorbent to the negative electrode can reduce infiltration of water or the like into the organic layer, thereby reducing display defect. In another embodiment, a passivation film, such as silicon nitride, may be provided on the negative electrode to reduce infiltration of water or the like into the organic compound layer. For example, the protecting layer may be formed by forming a negative electrode and then conveying the negative electrode to another chamber with the vacuum kept, on which a silicon nitride film with a thickness of 2 um is formed using a chemical vapor deposition method. The protecting layer may be formed using the CVD method and then an atom layer deposition method (ALD method). Examples of a material for the film using the ALD method include, but are not limited to, silicon nitride, silicon oxide, and aluminum oxide. Silicon nitride may be deposited using the CVD method on the film formed using the ALD method. The film formed using the ALD method may be thinner than the film formed using the CVD method. Specifically, the thickness may be 50% or less, or 10% or less.

[Color Filter]

A color filter may be provided on the protecting layer. For example, a color filter taking the size of the organic light-emitting element into account may be provided on another substrate, and the substrate may be bonded to the substrate of the organic light-emitting element or, alternatively, a color filter may be patterned on the protecting layer described above using a photolithography technique. The color filter may be made of a high polymer.

[Planarizing Layer]

A planarizing layer may be provided between the color filter and the protecting layer. The planarizing layer is provided to reduce the surface irregularities of the lower layer. The planarizing layer may also be referred to as a resin layer without limitation on the purpose. The planarizing layer may be made of an organic compound, which may be either low molecular or high molecular, and preferably high molecular.

The planarizing layer may be provided on and under the color filter and may be made of the same material or different materials. Specific examples include a polyvinyl carbazole resin, a polycarbonate resin, a polyester resin, an acrylonitrile-butadiene-styrene (ABS) resin, an acrylic resin, a polyimide resin, a phenol resin, an epoxy resin, a silicon resin, and an urea resin.

[Microlenses]

The organic light-emitting apparatus may include an optical member, such as microlenses, on the light-exiting side. The microlenses can be made of, for example, an acrylic resin or an epoxy resin. The microlenses may be provided to increase the amount of light to be extracted from the organic light-emitting apparatus and to control the direction of the light to be extracted. The microlenses may have a hemispherical shape. In the case of the hemispherical shape, a contact point between, among tangents in contact with the hemisphere, a tangent parallel to the insulating layer and the hemisphere is the apex of the microlens. The apex of the microlens can be determined also in any cross-sectional view. In other words, the apex of the microlens is the contact point between a tangent, among tangents in contact with the hemisphere of the microlens in the cross-sectional view, parallel to the insulating layer and the hemisphere.

The middle point of the microlens can also be defined. Assuming a line segment from a point at which the circular arc ends to a point at which another circular arc ends in a cross section of the microlenses, the middle point of the line segment can be referred to as the middle point of the microlens. The cross section in which the apex and the middle point are determined may be a cross section perpendicular to the insulating layer.

The microlenses may be formed by adjusting the exposing and developing processes. Specifically, a film (photoresist film) made of a material for the microlenses is formed, and the photoresist film is subjected to exposure and development using a mask having continuous gradation. Examples of the mask include a gray mask and an area gradation mask, which allows light having continuous gradation to be applied to an imaging plane by changing the density distribution of dots formed of a light shielding layer with a resolution lower than or equal to the resolution of the exposure device.

Etching back the microlenses formed using the exposing and developing processes allows the lens shape to be adjusted. The microlenses may have any shape having an inclined portion that allows radiated light to be refracted and may be spherical or asymmetric in cross section.

[Opposing Substrate]

An opposing substrate may be provided on the planarizing layer. The opposing substrate is named from the fact that it is provided at a position corresponding to the substrate. The constituent material of the opposing substrate may be the same as that of the above substrate. Assuming that the above substrates is a first substrate, the opposing substrate may be referred to as a second substrate.

[Forming Organic Layer]

The organic compound layer (a hole injection layer, a hole transport layer, an electron blocking layer, an emission layer, a hole blocking layer, an electron transport layer, an electron injection layer, a charge generating layer, and so on) constituting the organic light-emitting element according to an embodiment of the present invention is formed using the following method.
The organic compound layer constituting the organic light-emitting element according to an embodiment of the present invention can be formed by means of a dry process, such as a vacuum deposition method, an ionized deposition method, sputtering, or plasma. Instead of the dry process, a wet process may be used for forming the layer by coating an organic compound dissolved in an appropriate solvent using a known coating method (for example, spin coating, dipping, a cast method, a Langmuir-Blodgett (LB) method, or an ink-jet method).
Using the vacuum deposition method or the solution coating method to form the layer makes crystallization or the like unlikely to occur, providing high temporal stability. In forming the film using the coating method allows the film to be formed in combination with an appropriate binder resin.
Examples of the binder resin include, but are not limited to, a polyvinyl carbazole resin, a polycarbonate resin, a polyester resin, an ABS resin, an acrylic resin, a polyimide resin, a phenol resin, an epoxy resin, a silicon resin, and an urea resin.
These binder resins may be used alone as a homopolymer or a copolymer or in combination of two or more kinds. In addition, additives, such as a known plasticizer, an antioxidant, and an ultraviolet absorber, may be used in combination as required.

[Pixel Circuit]

The light-emitting apparatus may include a pixel circuit connected to the light-emitting element. The pixel circuit may be of an active-matrix type that controls the emission of the first light-emitting element and the second light-emitting element independently. The active-matrix circuit may employ voltage programming or current programming. The drive circuit includes a pixel circuit for each pixel. The pixel circuit may include a light-emitting element, a transistor for controlling the luminance of the light-emitting element, a transistor for controlling the emission timing, capacitance that holds the gate voltage of the transistor for controlling the luminance, and a transistor for connecting to the ground (GND) not via the light-emitting element.
The light-emitting apparatus includes a display area and a peripheral area around the display area. The display area includes the pixel circuit, and the peripheral area includes a display control circuit. The mobility of the transistors constituting the pixel circuit may be lower than the mobility of the transistors constituting the display control circuit.
The inclination of the current-voltage characteristics of the transistors constituting the transistor pixel circuit may be smaller than the inclination of the current-voltage characteristics of the transistors constituting the display control circuit. The inclination of the current-voltage characteristics can be measured from a so-called Vg-Ig characteristic.
The transistors constituting the pixel circuit are connected to the light-emitting element, for example, the first light-emitting element.

[Pixel]

The organic light-emitting apparatus includes a plurality of pixels. The pixels include subpixels that emit light of different colors. The subpixels may individually have RGB emission colors.
Each pixel emits light from an area referred to as a pixel opening. This area is the same as the first area. The pixel opening may be 15 um or less and 5 um or more in size. More specifically, the pixel opening may be 11 um, 9.5 um, 7.4 um, or 6.4 um in size.
The distance between the subpixels may be 10 um or less, specifically, 8 um, 7.4 um, or 6.4 $\mu$m.

The pixels can have a known arrangement in plan view. Examples include a stripe arrangement, a delta arrangement, a PenTile arrangement, and a Bayer arrangement. The subpixel may have any known shape in plan view. Examples include a quadrangular shape, such as a rectangular shape or a rhombus shape, and a hexagonal shape. Of course, the rectangular shape includes any nearly rectangular shape other than an exact shape. A combination of the shape of the subpixel and the pixel arrangement may be employed.

EXAMPLES

<EXAMPLE 1>

The specific effects of the present invention will be described using an example. In this example, a single-color organic light-emitting element was used. Table 1 shows microlenses height h/D, microlenses radius $\Phi$/D, and height L2/D of the upper surface of the color filter, which are normalized by interpixel pitch D.

The effects of the present invention are independent of whether single color or white, as described above, and a color filter or the like may be separately provided.

[Table 1]

| | |
|---|---|
| Microlens height h/D | 0.35 |
| Microlens radius $\Phi$/D | 0.47 |
| Height from transflective electrode to microlens lower surface L2/D | 0.56 |

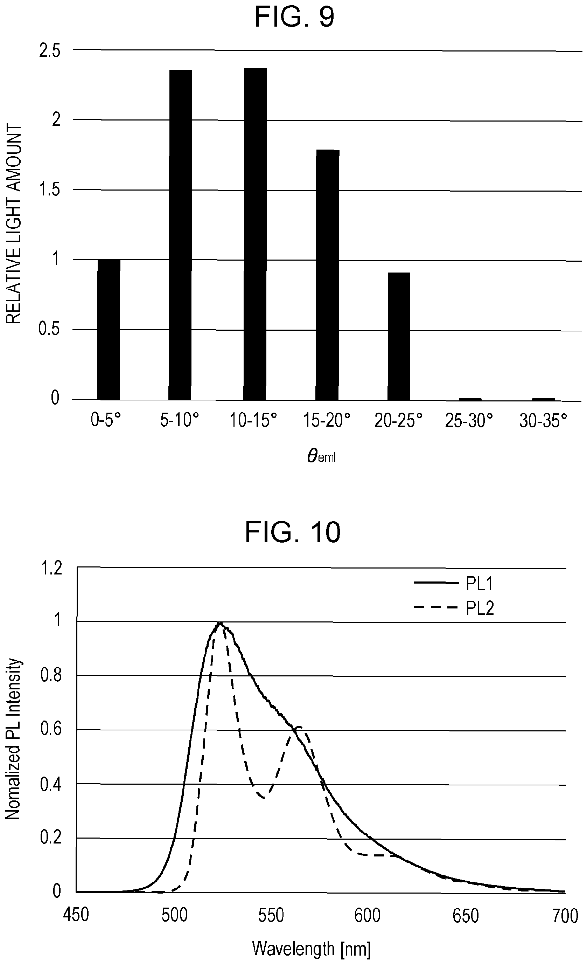

Fig. 9 is a graph showing the relationship between the emission angles and the relative intensities of an emission layer obtained from ray tracing. In ray tracing with the configuration of Table 1, the frontal direction was 10° to 15°, where the maximum relative intensity was obtained. In Example 1, an aluminum (Al) electrode was used as the reflecting layer, a 15-nm magnesium-silver alloy (MgAg) was used as the transflective electrode, and a silicon nitride (SiN) film was used as the protecting layer. The microlenses were formed with a material with a refractive index n of 1.5. Fig. 10 shows the PL spectrum PL1 of the light-emitting material used in Example 1. The maximum peak wavelength of the PL spectrum was 523 nm.

[Table 2]

| | | Order of Interference | | APL | $\lambda_{on}$ | $\lambda_{off}$ | Without Microlenses | | With Microlenses | | $\|\lambda_{EL} - \lambda_{PL}\|$ | $\|\lambda on - \lambda PL\|$ |
|---|---|---|---|---|---|---|---|---|---|---|---|---|
| | | m | m' | | | | Relative Radiation Intensity | $\lambda_{EL}(0)$ | Relative Radiation Intensity | AEL | | |
| D001 | Comparative Example | 1 | 0 | 523 nm | 523 nm | 504 nm | 1 | 523 nm | 1 | 519 nm | 4.0 nm | 0 nm |
| D101 | Example | 1 | 0 | 523 nm | 545 nm | 525 nm | 1 | 542 nm | 1.36 | 529 nm | 6.0 nm | 22 nm |
| D102 | Example | 1 | 0 | 523 nm | 552 nm | 531 nm | 0.99 | 549 nm | 1.4 | 530 nm | 7.0 nm | 29 nm |

Table 2 shows the test results. In this example, the test was conducted on the conditions that the order of interference m between the reflecting layer and the luminous point expressed by Exp. (4) was 1, and the order of interference m' between the luminous point and the translucent electrode was 0. In Comparative Example D001, the interference peak resonant wavelength $\lambda_{on}$ in the frontal direction coincided with $\lambda_{PL}$, and the interference peak resonant wavelength $\lambda_{off}$ in a direction inclined with respect to the substrate main surface was positioned closer to the short-wavelength side with respect to $\lambda_{PL}$ on the above conditions. In Examples D101 and D102, the interference peak resonant wavelength $\lambda_{off}$ in a direction inclined with respect to the substrate main surface was closer to $\lambda_{PL}$ on the condition that $\lambda_{on}$ was 545 nm and 552 nm, respectively. The relative radiation intensities in Table 2 are values normalized by the radiance of Comparative Example for configurations with microlenses and without microlenses.

First, the characteristics of the organic light-emitting elements without microlenses were compared. The interference conditions of D101 and D102 as compared with D001 showed that the EL spectrum peak intensity $\lambda_{EL}(0)$ in the frontal direction without microlenses shifted to the long-wavelength side with respect to $\lambda_{PL}$ and that the relative radiation intensity was equal to 1 or decreased to 0.99. In contrast, with microlenses, D101 and D102 showed that the relative radiation intensity increased to 1.36 and 1.4, respectively, and the EL peak wavelength $\lambda_{EL}$ was 529 nm and 530 nm, respectively, which are close to $\lambda_{PL}$ = 523 nm. This is due to the component around $\Theta_{eml}$ with the highest contributing rate of the components refracted in the frontal direction at the inclined portion of the microlens shown in Fig. 5(b) . In D101 and D102, the difference $|\lambda_{off} - \lambda_{PL}|$ between the interference peak resonant wavelength in the frontal direction and the PL peak wavelength was 22 nm and 29 nm, and the difference $|\lambda_{EL} - \lambda_{PL}|$ between the EL peak wavelength and the PL peak wavelength was 6 nm and 7 nm, respectively. Thus, the organic light-emitting element with the light extracting structure can increase the radiance in the frontal direction by adjusting the optical interference of the organic EL element so that $|\lambda_{EL} - \lambda_{PL}|$ is smaller than $|\lambda_{off} - \lambda_{PL}|$.

<EXAMPLE 2>

Example 2 is the same as Example 1 except that the spectrum shape of the light-emitting material has a double peak. The double peak means that the emission spectrum includes a first peak and a second peak.

[Table 3]

| | | Order of Interference | | $\lambda_{PL}$ | $\lambda_{on}$ | $\lambda_{off}$ | Without Microlenses | | With Microlenses | | $|\lambda_{EL} - \lambda PL|$ | $|\lambda on - \lambda PL|$ |
|---|---|---|---|---|---|---|---|---|---|---|---|---|
| | | m | m' | | | | Relative Radiation Intensity | $\lambda_{EL}(0)$ | Relative Radiation Intensity | AEL | | |
| D002 | Comparative Example | 1 | 0 | 523 nm | 523 nm | 504 nm | 1 | 523 nm | 1 | 522 nm | 1.0 nm | 0 nm |
| D103 | Example | 1 | 0 | 523 nm | 545 nm | 525 nm | 1 | 542 nm | 1.4 | 524 nm | 1.0 nm | 22 nm |
| D104 | Example | 1 | 0 | 523 nm | 552 nm | 531 nm | 0.98 | 549 nm | 1.45 | 524 nm | 1.0 nm | 29 nm |

Table 3 shows $\lambda_{PL}$, $\lambda_{on}$, $\lambda_{off}$, and the front radiation intensity in Example 2, in which the difference between $\lambda_{PL}$, $\lambda_{EL}$, and $\lambda_{on}$ under the individual conditions are listed. In Comparative Example D002, the interference peak resonant wavelength $\lambda_{on}$ in the frontal direction coincided with $\lambda_{PL}$, and the interference peak resonant wavelength $\lambda_{off}$ in a direction inclined with respect to the substrate main surface was positioned closer to the short-wavelength side with respect to $\lambda_{PL}$ on the above conditions. In Examples D103 and D104, the interference peak resonant wavelength $\lambda_{off}$ in a direction inclined with respect to the substrate main surface was closer to $\lambda_{PL}$ on the condition that $\lambda_{on}$ was 545 nm and 552 nm, respectively. The relative radiation intensities in Table 3 are values normalized by the radiance of D002.

First, comparison is made for the configuration without microlenses. The interference conditions of D103 and D104 as compared with D002 showed that the EL spectrum peak intensity $\lambda_{EL}(0)$ in the frontal direction without microlenses shifted to 542 nm and 549 nm, respectively, to the long-wavelength side with respect to $\lambda_{PL}$ = 523 nm and that the relative radiation intensity was equal to 1 or decreased to 0.98. In contrast, with microlenses, D103 and D104 showed that the relative radiance increased to 1.4 and 1.45, respectively, and the EL peak wavelength $\lambda_{EL}$ was 524 nm in both of D103 and D104, which is close to $\lambda_{PL}$ = 523 nm. This is due to the component around $\Theta_{eml}$ with the highest contributing rate of the components refracted in the frontal direction at the inclined portion of the microlens shown in Fig. 5(b) . In D103 and D104, the difference $|\lambda_{off} - \lambda_{PL}|$ between the interference peak resonant wavelength $\lambda_{on}$ in the frontal direction and the PL peak wavelength was 22 nm and 29 nm, respectively, and the difference $|\lambda_{EL} - \lambda_{PL}|$ between the EL peak wavelength and the PL peak wavelength was 1 nm in both of D103 and D104. This shows that the present invention is useful for the luminescence dopant having the PL spectrum shape with the second peak like PL2.

<EXAMPLE 3>

Example 3 is the same as Example 2 except that the order of interference m between the reflecting layer and the luminous point is 0 that the translucent electrode was 23 nm. Table 4 shows the test results of Example 3.

[Table 4]

| | | Order of Interference | | $\lambda_{PL}$ | $\lambda_{on}$ | $\lambda_{off}$ | Without Microlenses | | With Microlenses | | $|\lambda_{EL} - \lambda_{PL}|$ | $|\lambda_{on} - \lambda_{PL}|$ |
| | | m | m' | | | | Relative Radiation Intensity | $\lambda_{EL}(0)$ | Relative Radiation Intensity | AEL | | |
|---|---|---|---|---|---|---|---|---|---|---|---|---|
| D003 | Comparative Example | 0 | 0 | 523 nm | 524 nm | 510 nm | 1 | 524 nm | 1 | 522 nm | 1.0 nm | 1 nm |
| D105 | Example | 0 | 0 | 523 nm | 539 nm | 524 nm | 0.9 | 528 nm | 1.36 | 524 nm | 1.0 nm | 16 nm |

In Comparative Example D003, the interference peak resonant wavelength $\lambda_{on}$ in the frontal direction coincided with $\lambda_{PL}$, and the interference peak resonant wavelength $\lambda_{off}$ in a direction inclined with respect to the substrate main surface was positioned closer to the short-wavelength side with respect to $\lambda_{PL}$ on the above conditions. In Example D105, the interference peak resonant wavelength $\lambda_{off}$ in a direction inclined with respect to the substrate main surface was 534 nm, close to $\lambda_{PL}$ = 523 nm, on the condition that $\lambda_{on}$ was 539 nm. The relative radiation intensity in Table 4 is a value normalized by the radiance of D003.

First, comparison is made for the configuration without microlenses. The interference conditions of D105 as compared with D003 showed that the EL spectrum peak intensity $\lambda_{EL}(0)$ in the frontal direction without microlenses shifted to 528 nm to the long-wavelength side with respect to $\lambda_{PL}$ = 523 nm and that the relative radiation intensity was decreased to 0.9. In contrast, with microlenses, the relative radiance of D105 increased to 1.36, and the EL peak wavelength $\lambda_{EL}$ was 524 nm, which is close to $\lambda_{PL}$ = 523 nm. This is due to the component around $\Theta_{eml}$ with the highest contributing rate of the components refracted in the frontal direction at the inclined portion of the microlens shown in Fig. 5(b) . In D105, the difference $|\lambda_{off} - \lambda_{PL}|$ between the interference peak resonant wavelength $\lambda_{on}$ in the frontal direction and the PL peak wavelength was 16 nm, and the difference $|\lambda_{EL} - \lambda_{PL}|$ between the EL peak wavelength and the PL peak wavelength was 1 nm. This shows that the present invention exhibits the effects also for the case where the order of interference m between the reflecting layer and the luminous point is 0.

<EXAMPLE 4>

Example 4 is the same as Example 2 except that the order of interference m' between the translucent electrode and the luminous point is 1. Table 5 shows the test results of Example 4.

[Table 5]

| | | Order of Interference | | $\lambda_{PL}$ | $\lambda_{on}$ | $\lambda_{off}$ | Without Microlenses | | With Microlenses | | $|\lambda_{EL} - \lambda_{PL}|$ | $|\lambda_{on} - \lambda_{PL}|$ |
|---|---|---|---|---|---|---|---|---|---|---|---|---|
| | | m | m' | | | | Relative Radiation Intensity | $\lambda_{EL}(0)$ | Relative Radiation Intensity | AEL | | |
| D004 | Comparative Example | 0 | 1 | 523 nm | 523 nm | 505 nm | 1 | 524 nm | 1 | 521 nm | 2 nm | 0 nm |
| D106 | Example | 0 | 1 | 523 nm | 538 nm | 520 nm | 0.84 | 528 nm | 1.13 | 524 nm | 1nm | 15 nm |

In Comparative Example D004, the interference peak resonant wavelength $\lambda_{on}$ in the frontal direction coincided with $\lambda_{PL}$, and the interference peak resonant wavelength $\lambda_{off}$ in a direction inclined with respect to the substrate main surface was positioned closer to the short-wavelength side with respect to $\lambda_{PL}$ on the above conditions. In Example D106, the interference peak resonant wavelength $\lambda_{off}$ in a direction inclined with respect to the substrate main surface was 520 nm, close to $\lambda_{PL}$ = 523 nm, on the condition that $\lambda_{on}$ was 538 nm. The relative radiation intensity in Table 5 is a value normalized by the radiance of D004.

First, comparison is made for the configuration without microlenses. The interference conditions of D106 as compared with D004 showed that the EL spectrum peak intensity $\lambda_{EL}(0)$ in the frontal direction without microlenses shifted to 528 nm to the long-wavelength side with respect to $\lambda_{PL}$ = 523 nm and that the relative radiation intensity was decreased to 0.84. In contrast, with microlenses, the relative radiance of D105 increased to 1.13, and the EL peak wavelength $\lambda_{EL}$ was 524 nm, which is close to $\lambda_{PL}$ = 523 nm. This is due to the component around $\Theta_{eml}$ with the highest contributing rate of the components refracted in the frontal direction at the inclined portion of the microlens shown in Fig. 5(b) . In D106, the difference $|\lambda_{off} - \lambda_{PL}|$ between the interference peak resonant wavelength $\lambda_{on}$ in the frontal direction and the PL peak wavelength was 15 nm, and the difference $|\lambda_{EL} - \lambda_{PL}|$ between the EL peak wavelength and the PL peak wavelength was 1 nm. This shows that the present invention exhibits the effects also for the case where the order of interference m between the translucent electrode and the luminous point is 1.

Thus, the effects of the present invention were independent of the shape of the PL spectrum of luminescence dopant and the order of interference.

[Application of Organic Light-Emitting Element According to Embodiment of the Present Invention]

The organic light-emitting element according to an embodiment of the present invention can be used as a component of a display apparatus or an illumination apparatus. Other applications include an exposing light source of an electrophotographic image forming apparatus, a backlight of a liquid crystal display apparatus, and a light-emitting apparatus having a color filter for a white light source.

The display apparatus may be an image-information processing apparatus including an image input unit that receives image information from an area charge-coupled device (CCD), a linear CCD, a memory card, or the like and an information processing unit that processes the input information and configured to display the input image on a display.

The display of an image pickup apparatus or an ink-jet printer may have a touch panel function. Examples of a driving method for the touch panel function include, but are not limited to, an infrared method, a capacitive sensing method, a resistive method, and an electromagnetic induction method. The display apparatus may be used as the display of a multifunction printer.

Next, the display apparatus according to this embodiment will be described with reference to the drawings.

The light-emitting element according to an embodiment of the present invention may be used in an image forming apparatus. The image forming apparatus includes a photosensitive member, an exposing light source, a developing unit, a charging unit, a transfer unit, a conveying roller, and a fixing unit.

Light is emitted from the exposing light source to form an electrostatic latent image on the surface of the photosensitive member. The exposing light source includes an organic light-emitting element according to the present invention. The developing unit includes toner or the like. The charging unit charges the photosensitive member. The transfer unit transfers a developed image to a printing medium. The conveying unit conveys the printing medium. One example of the printing medium is paper. The fixing unit fixes the image formed on the printing medium.

The exposing light source may include a plurality of light-emitting portions arranged on a long substrate. The column direction in which the organic light-emitting elements are arrayed may be the axial direction of the photosensitive member. The column direction is the same as the direction of the axis of rotation of the photosensitive member. This direction may also be referred to as the long axis direction of the photosensitive member.

The light-emitting portions may be arranged alternately in the column direction in the first column and the second column. The light-emitting portions in the first column and the second column are arranged at different positions in the row direction.

The first column may have a plurality of light-emitting portions arranged at intervals. The second column has light-emitting portions at the positions corresponding to the interval between the light-emitting portions in the first column. In other words, a plurality of light-emitting portions may be arranged at intervals also in the row direction. The light-emitting elements may be arranged, for example, in the form of a grid, in a staggered pattern, or in a checkerboard pattern.

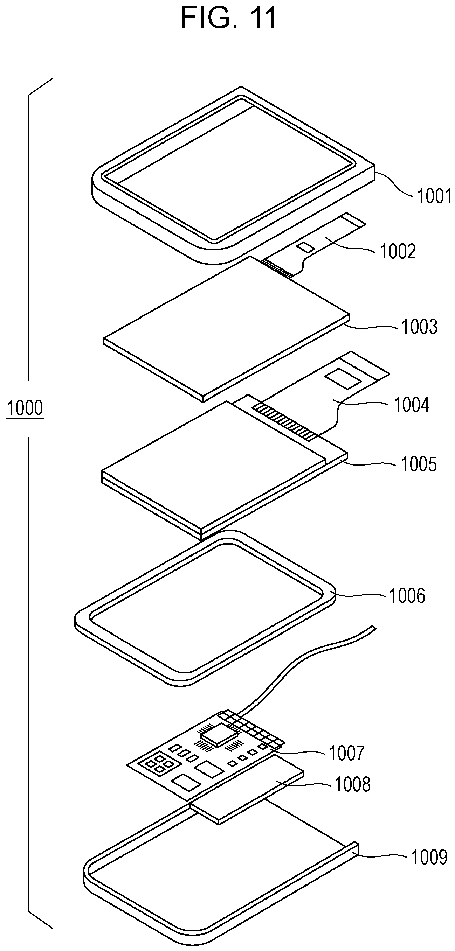

Fig. 11 is a schematic diagram illustrating an example of the light-emitting apparatus according to this embodiment. The display apparatus 1000 may include a touch panel 1003, a display panel 1005, a frame 1006, a circuit board 1007, and a battery 1008 between an upper cover 1001 and a lower cover 1009. The touch panel 1003 and the display panel 1005 connect to flexible printed circuits (FPCs) 1002 and 1004, respectively. The circuit board 1007 has transistors printed thereon. The battery 1008 is not needed unless the display apparatus is a mobile phone and, if it is a mobile phone, may be disposed at another position. The light-emitting apparatus is included in the display panel.

The display apparatus according to this embodiment may include a color filter including red, green, and blue. The color filter may be arranged in a delta array of red, green, and blue.

The display apparatus according to this embodiment may be used as the display of a mobile terminal. In this case, the display apparatus may have both a display function and an operating function. Examples of the mobile terminal include a mobile phone, such as a smartphone, a tablet, and a head-mounted display. The display apparatus may include a display control unit that controls an image to be displayed.

The light-emitting apparatus according to this embodiment may be used for the display of an image pickup apparatus including an optical part including a plurality of lenses and an image sensor that receives light passing through the optical part. The image pickup apparatus may include a display that displays information acquired by the image sensor. The display may be exposed out of the image pickup apparatus or disposed in the finder. The image pickup apparatus may be either a digital camera or a digital video camera.

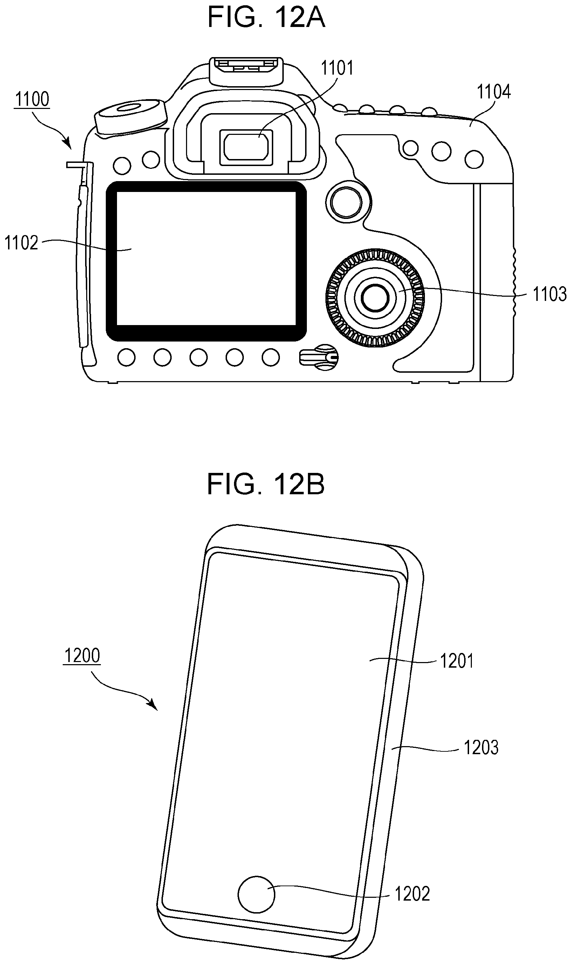

Fig. 12A is a schematic diagram illustrating an example of the image pickup apparatus according to this embodiment. The image pickup apparatus 1100 may include a viewfinder 1101, a back display 1102, an operating portion 1103, and a casing 1104. The viewfinder 1101 may include the light-emitting apparatus according to this embodiment. In this case, the display apparatus may display not only the image to be captured but also environmental information and image-capturing instructions. The environmental information may include the intensity and the direction of outside light, the moving speed of the subject, and the possibility that the subject is shielded by a shield.

The information should be displayed as fast as possible because the best timing for image capturing is short. Accordingly, it is preferable to use the organic light-emitting apparatus according to the present invention. This is because the organic light-emitting element has a fast response speed. The organic light-emitting apparatus can be used more suitably for apparatuses that require high display speed than liquid crystal display apparatuses.

The image pickup apparatus 1100 includes an optical part (not shown). The optical part includes a plurality of lenses and forms an image on an image sensor housed in the casing 1104. Adjusting the relative positions of the plurality of lenses allows the focal point to be adjusted. This operation can be automatically performed. The image pickup apparatus may be referred to as a photoelectric conversion apparatus. The photoelectric conversion apparatus can adopt not sequential image capturing but a method of detecting the difference from the previous image, a method of clipping an image from regularly recorded images, and other image capturing methods.

Fig. 12B is a schematic diagram illustrating an example of an electronic apparatus according to this embodiment. The electronic apparatus 1200 includes a display 1201, an operating portion 1202, and a casing 1203. The casing 1203 may include a circuit, a printed board including the circuit, a battery, and a communicating portion. The operating portion 1202 may be either a button or a touch panel type reaction portion. The operating portion may be a living-organism recognizing portion. An electronic apparatus including a communicating portion may also be referred to as a communication apparatus. The electronic apparatus may further have a camera function by including a lens and an image sensor. An image captured using the camera function is displayed on the display. Examples of the electronic apparatus include a smartphone and a notebook computer.

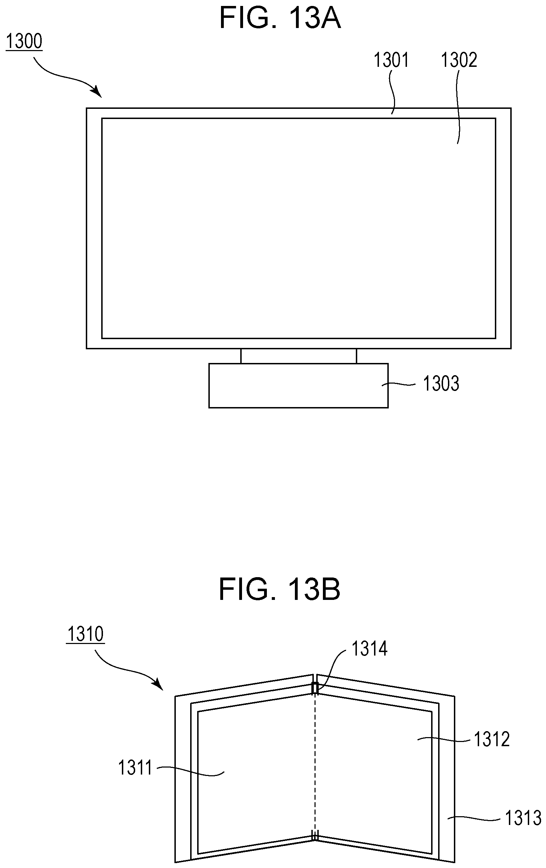

Figs. 13A and 13B are schematic diagrams illustrating examples of the light-emitting apparatus according to this embodiment. Fig. 13A illustrates a display apparatus, such as a television monitor or a personal computer (PC) monitor. The display apparatus 1300 includes a frame 1301 and a display 1302. The display 1302 may include the light-emitting apparatus according to this embodiment.

The display apparatus 1300 includes a base 1303 that supports the frame 1301 and the display 1302. The shape of the base 1303 does not have to be he shape shown in Fig. 4A. The lower side of the frame 1301 may also serve as the base.

The frame 1301 and the display 1302 may be curved. The radius of curvature may be 5,000 mm or more and 6,000 mm or less.

Fig. 13B is a schematic diagram illustrating another example of the light-emitting apparatus according to this embodiment. A display apparatus 1310 in Fig. 13B is configured to be foldable, that is, a foldable display apparatus. The display apparatus 1310 includes a first display 1311, a second display 1312, a casing 1313, and a folding point 1314. The first display 1311 and the second display 1312 may each have the light-emitting apparatus according to this embodiment. The first display 1311 and the second display 1312 may be one seamless display apparatus. The first display 1311 and the second display 1312 can be divided by the folding point. The first display 1311 and the second display 1312 may display different images or display one image with the first and the second display.

The light-emitting apparatus according to this embodiment may be used in an illumination apparatus. The illumination apparatus may include a casing, a light source, a circuit board, an optical film, and a light diffusing unit. The light source may include the light-emitting apparatus according to this embodiment. The optical filter may be a filter that enhances the color rendering property of the light source. The light diffusing unit can diffuse the light from the light source efficiently, for example, light up, to deliver the light to a wide area. The optical filter and the light diffusing unit may be disposed on the light emission side. A cover may be provided on the outermost periphery as needed.

An example of the illumination apparatus is an apparatus that illuminates the room. The illumination apparatus may emit any of white, natural white, and blue to red lights. The illumination apparatus may include a dimmer circuit that controls the light. The illumination apparatus may include the organic light-emitting element according to the present invention and a power circuit connected thereto. The power circuit converts an alternating-current voltage to a direct-current voltage. The white light has a color temperature of 4,200 K. The natural white light has a color temperature of 5,000 K. The illumination apparatus may include a color filter.

The illumination apparatus according to this embodiment may include a heat radiator. The heat radiator releases the heat in the apparatus to the outside. Examples include metal and liquid silicon with high specific heat.

The light-emitting apparatus according to the present invention may be used in a moving object, such as an automobile. The automobile includes a tail lamp, which is an example of lighting fixtures. The automobile may include a tail lamp and may be configured to light on the tail lamp at a brake operation or the like.

The tail lamp may include the light-emitting apparatus according to this embodiment. The tail lamp may include a protector that protects the organic light-emitting elements. The protector may be made of any transparent material with relatively high strength, preferably, polycarbonate. The polycarbonate may be mixed with a furandicarboxylic acid derivative, an acrylonitrile derivative, or the like.

The automobile may include a body and windows mounted thereto. The windows may include a transparent display if they are not for checking the front and back of the automobile. The transparent display may include the organic light-emitting apparatus according to this embodiment. In this case, the components of the organic light-emitting elements, such as electrodes, are made of transparent materials.

The moving object according to this embodiment may be a ship, an aircraft, a drone, or the like. The moving object may include a body and a lighting fixture provided on the body. The lighting fixture may emit light for indicating the position of the body. The lighting fixture includes the organic light-emitting element according to this embodiment.

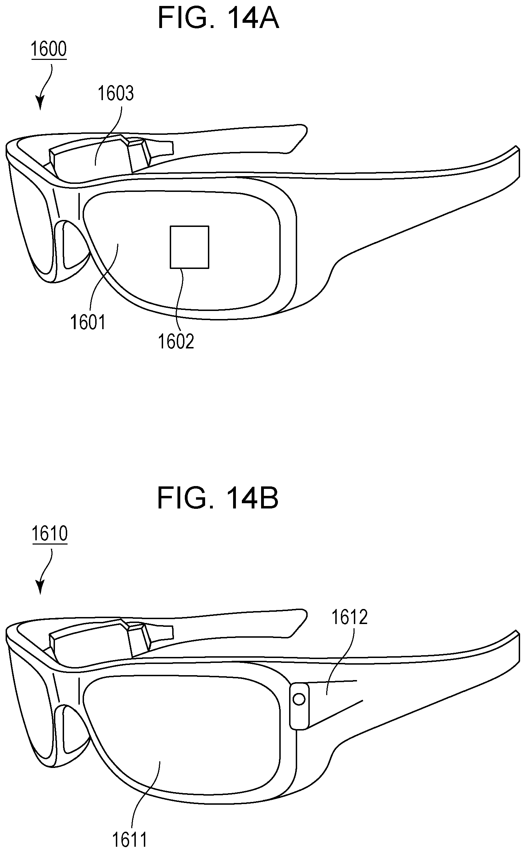

Referring to Figs. 14A and 14b, applications of the display apparatuses according to the above embodiments will be described. The display apparatuses are applicable to wearable systems including smartglasses, head-mounted displays (HMDs), smart contact lenses, and other wearable devices. An image-capturing display apparatus used in such applications includes an image pickup apparatus capable of photoelectrically converting visible light and a display apparatus capable of emitting visible light.

Fig. 14A illustrates a pair of glasses 1600 (smartglasses) according to an application. The pair of glasses 1600 includes an image pickup apparatus 1602, such as a complementary metal-oxide semiconductor (CMOS) sensor or a single photon avalanche diode (SPAD), on the front surface of a lens 1601. The display apparatus of each embodiment is provided on the back of the lens 1601.

The pair of glasses 1600 further includes a control unit 1603. The control unit 1603 functions as a power source for supplying electricity to the image pickup apparatus 1602 and the display apparatus according to each embodiment. The control unit 1603 controls the operation of the image pickup apparatus 1602 and the display apparatus. The lens 1601 is provided with an optical part for collecting light to the image pickup apparatus 1602.

Fig. 14B illustrates a pair of glasses (smartglasses) 1610 according to an application. The pair of glasses 1610 includes a control unit 1612. The control unit 1612 is equipped with an image pickup apparatus corresponding to the image pickup apparatus 1602 and a display apparatus. A lens 1611 is equipped with an optical part for projecting the light from the image pickup apparatus and the display apparatus in the control unit 1612, and an image is projected on the lens 1611. The control unit 1612 functions as a power source for supplying electricity to the image pickup apparatus and the display apparatus and controls the operation of the image pickup apparatus and the display apparatus. The control unit may include a gaze detection unit that detects the gaze of the wearer. The gaze detection may use infrared light. An infrared emission unit emits infrared light to the eyeball of a user who is looking at the displayed image. The image pickup unit including light receiving elements detects the reflected light of the infrared light from the eyeball, so that an image of the eyeball is obtained. A reducing unit that reduces the light from the infrared emission unit to the display in plan view reduces a decrease in image quality.

The gaze of the user at the displayed image is detected from the image of the eyeball using infrared light. The gaze detection using the image of the eyeball may use any known technique. An example is an eye-gaze tracking method based on Purkinje images obtained by the reflection of illuminated light on the cornea.

More specifically, a gaze tracking process based on pupil center corneal reflection is performed. The gaze of the user is detected by calculating a gaze vector indicating the orientation (rotation angle) of the eyeball on the basis the image of the pupil contained in the image of the eyeball and Purkinje images using pupil center corneal reflection.

A display apparatus according to an embodiment of the present invention may include an image pickup apparatus including a light receiving element and may control an image displayed on the display apparatus on the basis of user gaze information provided from the image pickup apparatus.

Specifically, the display apparatus determines a first view area at which the user gazes and a second view area other than the first view area on the basis of the gaze information. The first view area and the second view area may be determined by the control unit of the display apparatus or may be received from an external control unit. The display resolution of the first view area in the display area of the display apparatus may be set higher than the display resolution of the second view area. In other words, the resolution of the second view area may be set lower than the resolution of the first view area.

The display area includes a first display area and a second display area different from the first display area. A higher priority area is determined from the first display area and the second display area on the basis of the gaze information. The first view area and the second view area may be determined by the control unit of the display apparatus or may be received from an external control unit. The resolution of a higher priority area may be set higher than the resolution of the area other than the higher priority area. In other words, the resolution of the lower priority area may be set low.

The determination of the first view area and the higher priority area may use artificial intelligence (AI). The AI may be of a model configured to estimate the gaze angle and the distance from an image of the eyeball to the object of the gaze using the image of the eyeball and the direction of the actual gaze of the eyeball in the image as training data. An AI program may be installed in the display apparatus, the image pickup apparatus, or an external apparatus. The AI program, if installed in an external apparatus, is sent to the display apparatus via communication.

Display control based on visual recognition allows application to smartglasses that further includes an image pickup apparatus that captures an external image. Smartglasses can display captured external information in real time.

Thus, using an apparatus including the organic light-emitting element according to this embodiment allows stable display with high image quality even for long time display.

It is to be understood that the present invention is not limited to the above embodiments and that various changes and modifications may be made without departing from the spirit and scope of the present invention. Accordingly, the following claims are attached to publicly disclose the present invention.

This application claims the benefit of Japanese Patent Application No. 2021-067635 filed April 13, 2021 and No. 2022-018103 filed February 8, 2022), which are hereby incorporated by reference herein in their) entirety.

Reference Signs List

| 1 | DISPLAY AREA |
| 2 | END OF DISPLAY AREA |
| 3 | LIGHT-EMITTING ELEMENT |
| 3' | DUMMY PIXEL |
| 4 | OPTICAL MEMBER |
| 5 | SUBSTRATE |
| 6 | REFLECTING LAYER |
| 7 | ORGANIC LAYER |
| 8 | TRANSFLECTIVE ELECTRODE |
| 9 | PROTECTING LAYER |
| 10 | MICROLENS |
| 11 | LUMINOUS POINT |
| 12 | EMISSION LIGHT |
| 13 | INCLINED PORTION |
| 14 | DISTANCE FROM PIXEL CENTER OF LIGHT EMITTING POSITION |
| 15 | LUMINOUS AREA |
| 16 | LIGHT EXTRACTING SURFACE |
| 17 | INCLINATION ANGLE |
| 18 | LUMINOUS AREA |
| 19 | LIGHT EXTRACTING SURFACE |
| 20 | LUMINOUS REGION THAT EMITS LIGHT IN FRONTAL DIRECTION |
| 21 | PIXEL SEPARATING LAYER |
| 22 | LUMINOUS REGION |
| 23 - 26 | ΔML |
| 27 | COLOR FILTER |
| 28 | PROTECTIVE GLASS |
| 29 | OPTICAL ADJUSTMENT LAYER |
| 30 | TRANSPARENT ELECTRODE |
| 31 | FILLING LAYER |
| 1000 | DISPLAY APPARATUS |
| 1001 | UPPER COVER |

1002    FLEXIBLE PRINTED CIRCUIT
1003    TOUCH PANEL
1004    FLEXIBLE PRINTED CIRCUIT
1005    DISPLAY PANEL
1006    FRAME
1007    CIRCUIT BOARD
1008    BATTERY
1009    LOWER COVER
1100    IMAGE PICKUP APPARATUS
1101    VIEWFINDER
1102    BACK DISPLAY
1103    OPERATING PORTION
1104    CASING
1200    ELECTRONIC APPARATUS
1201    DISPLAY
1202    OPERATING PORTION
1203    CASING
1300    DISPLAY APPARATUS
1301    FRAME
1302    DISPLAY
1303    BASE
1310    DISPLAY APPARATUS
1311    FIRST DISPLAY
1312    SECOND DISPLAY
1313    CASING
1314    FOLDING POINT
1600    SMARTGLASSES
1601    LENS
1602    IMAGE PICKUP APPARATUS
1603    CONTROL UNIT
1610    SMARTGLASSES
1611    LENS
1612    CONTROL UNIT

**Claims**

1.  A light-emitting apparatus comprising:

    an insulating layer;
    a light-emitting element disposed on a main surface of the insulating layer, the light-emitting element containing a light-emitting material and having a resonator structure; and
    a lens disposed above the light-emitting element, a photoluminescence (PL) spectrum of the light-emitting material having a first peak with a wavelength $\lambda_{PL}$ in a visible light range,
    wherein the resonator structure satisfies Exp. (1),

$$|\lambda_{EL} - \lambda_{PL}| < |\lambda_{on} - \lambda_{PL}| \quad (1)$$

    where $\lambda_{on}$ is a resonance peak wavelength of an interference spectrum that reinforces light emitted in a direction perpendicular to the main surface and $\lambda_{EL}$ is a peak wavelength of electroluminescence radiated via the light extracting structure.

2.  The light-emitting apparatus according to Claim 1, wherein, in the PL spectrum, the first peak is a maximum intensity peak in the visible light range.

3.  The light-emitting apparatus according to Claim 1 or 2, wherein the PL peak wavelength $\lambda_{PL}$ is a wavelength of a peak closest to the $\lambda_{on}$ among the PL peak wavelengths.

4. A light-emitting apparatus comprising:

an insulating layer;
a light-emitting element disposed on a main surface of the insulating layer, the light-emitting element containing a light-emitting material and having a resonator structure; and
a lens disposed above the light-emitting element, a photoluminescence (PL) spectrum of the light-emitting material having a first peak with a wavelength $\lambda_{PL}$ in a visible light range,
wherein the resonator structure satisfies Exp. (2),

$$|\lambda_{\mathrm{off}} - \lambda_{\mathrm{PL}}| < |\lambda_{\mathrm{on}} - \lambda_{\mathrm{PL}}| \quad (2)$$

where $\lambda_{\mathrm{on}}$ is a resonance peak wavelength of an interference spectrum that reinforces light emitted in a direction perpendicular to the main surface and $\lambda_{\mathrm{off}}$ is a resonance peak wavelength of an interference spectrum that reinforces light emitted in the direction perpendicular to the main surface due to refraction in the light extracting structure.

5. The light-emitting apparatus according to Claim 4,
wherein the PL spectrum of the light-emitting material has a second peak with an emission intensity lower than the first peak and having a wavelength $\lambda_{PL2}$, and
wherein Exp. (3) is satisfied,

$$|\lambda_{\mathrm{off}} - \lambda_{\mathrm{PL}}| \leq |\lambda_{\mathrm{on}} - \lambda_{\mathrm{PL2}}| \quad (3)$$

6. The light-emitting apparatus according to Claim 5,

wherein, in the PL spectrum, the first peak is a maximum intensity peak in the visible light range, and
wherein the second peak is a second highest intensity peak after the first peak.

7. The light-emitting apparatus according to any one of Claims 4 to 6, wherein the PL peak wavelength $\lambda_{PL}$ is a wavelength of a peak closest to the $\lambda_{\mathrm{on}}$ among the PL peak wavelengths.

8. The light-emitting apparatus according to any one of Claims 1 to 7, wherein the $\lambda_{\mathrm{on}}$ is longer than the PL peak wavelength $\lambda_{PL}$.

9. The light-emitting apparatus according to any one of Claims 1 to 8,

wherein the light extracting structure includes an inclined portion inclined with respect to the main surface, and
wherein the inclined portion refracts light traveling in a direction inclined with respect to the main surface in the direction perpendicular to the main surface.

10. The light-emitting apparatus according to Claim 9,
wherein the inclined portion has an inclination angle of 9° or more and 60° or less with respect to the main surface.

11. The light-emitting apparatus according to Claim 9 or 10, wherein an emission angle $\Theta_{\mathrm{eml}}$ of light refracted in a frontal direction at the inclined portion of the light extracting structure with respect to the main surface of an emission layer of the light-emitting element is larger than 0° and less than 30°.

12. The light-emitting apparatus according to any one of Claims 9 to 11, wherein the emission angle $\Theta_{\mathrm{eml}}$ of the light refracted in the frontal direction at the inclined portion of the light extracting structure with respect to the main surface of the emission layer of the light-emitting element is 5° or more and 20° or less.

13. The light-emitting apparatus according to any one of Claims 1 to 12,

wherein the light-emitting element includes:

an electrode that supplies electrical charge to the light-emitting material; and

a pixel separating layer covering one end and another end of the electrode, and

wherein, in a cross section perpendicular to the main surface of the substrate, a middle point of the light extracting structure and a middle point between the one end and the other end of the pixel separating layer in a direction parallel to the main surface are not superposed on each other in plan view.

14. The light-emitting apparatus according to any one of Claims 1 to 13,

wherein the display area includes a first area including a central portion of the display area and a second area outside the first area,
wherein the first area includes a third light-emitting element, and the second area includes a fourth light-emitting element, and
wherein a distance between the middle point of the light extracting structure in the fourth light-emitting element and the middle point between the one end and the other end of the pixel separating layer is larger than a distance between the middle point of the light extracting structure in the third light-emitting element and the middle point between the one end and the other end of the pixel separating layer.

15. The light-emitting apparatus according to Claim 13 or 14, further comprising:

a light-emitting portion containing the light-emitting material,
wherein, when, in the cross section perpendicular to the main surface of the substrate, the middle point of the light extracting structure and the middle point between the one end and the other end of the pixel separating layer in the direction parallel to the main surface are not superposed on one another in plan view, an optical distance of the $\lambda_{off}$ is a distance between a curve far from the light-emitting portion of a curve of the lens and the light-emitting portion in the cross section.

16. The light-emitting apparatus according to any one of Claims 1 to 15, further comprising:

a second light-emitting element with a resonator structure different from the resonator structure of the light-emitting element,
wherein the second light-emitting element reinforces light with a wavelength different from the wavelength of the light-emitting element.

17. The light-emitting apparatus according to Claim 16,

wherein the light-emitting element includes a first optical adjustment layer, and the second light-emitting element includes a second optical adjustment layer, and
wherein the first optical adjustment layer is smaller in thickness than the second optical adjustment layer.

18. The light-emitting apparatus according to any one of Claims 1 to 17, further comprising:

a second light-emitting element different from the light-emitting element,
wherein the second light-emitting element does not satisfy Exp. (1).

19. The light-emitting apparatus according to Claim 4, further comprising:

a second light-emitting element different from the light-emitting element,
wherein the second light-emitting element does not satisfy Exp. (2).

20. The light-emitting apparatus according to any one of Claims 16 to 19,

wherein the emission spectrum of the light-emitting material has a first half width at half maximum,
wherein the second light-emitting element contains a second light-emitting material,
wherein an emission spectrum of the second light-emitting material has a second half width at half maximum, and
wherein the second half width at half maximum of the second light-emitting material is larger than the first half width at half maximum of the first light-emitting material.

21. The light-emitting apparatus according to Claim 20,

wherein the second light-emitting material comprises a phosphorescence emitting material.

22. The light-emitting apparatus according to any one of Claims 1 to 21, wherein the light-emitting material of the first light-emitting element comprises a fluorescence emitting material.

23. The light-emitting apparatus according to any one of Claims 1 to 22, further comprising:

a second light-emitting element different from the light-emitting element; and
a second light extracting structure different from the light extracting structure and receiving light from the second light-emitting element,
wherein, in a cross section perpendicular to the main surface, a distance in a direction parallel to the main surface between a middle point of a luminous region of the light-emitting element and a middle point of the light extracting structure is larger than a distance in the direction parallel to the main surface between a middle point of a luminous region of the second light-emitting element and a middle point of the second light extracting structure in the cross section perpendicular to the main surface.

24. The light-emitting apparatus according to Claim 23, further comprising:

a third light-emitting element different from the second light-emitting element; and
a third light extracting structure different from the second light extracting structure and receiving light from the third light-emitting element,
wherein, in a cross section perpendicular to the main surface, a distance in the direction parallel to the main surface between a middle point of a luminous region of the second light-emitting element and a middle point of the second light extracting structure is larger than a distance in the direction parallel to the main surface between a middle point of a luminous region of the third light-emitting element and a middle point of the third light extracting structure in the cross section perpendicular to the main surface.

25. A display apparatus comprising:

the light-emitting apparatus according to any one of Claims 1 to 24; and
a display control unit connected to the light-emitting apparatus.

26. An image pickup apparatus comprising:

an optical part including a plurality of lenses;
an image sensor that receives light passing through the optical part; and
a display that displays an image captured by the image sensor,
wherein the display includes the light-emitting apparatus according to any one of Claims 1 to 24.

27. An electronic apparatus comprising:

a display including the light-emitting apparatus according to any one of Claims 1 to 24;
a casing including the display; and
a communicating portion provided at the casing and communicating with outside.

# FIG. 1A

# FIG. 1B

## FIG. 2A

## FIG. 2B

# FIG. 3A

16a

15a

20a

20a

# FIG. 3B

# FIG. 4A

# FIG. 4B

# FIG. 4C

# FIG. 4D

# FIG. 5

(a)

$\lambda$on=$\lambda_{PL}$

Relative Intensity

Wavelength [nm]

$\Theta_{eml}$
— 0°
--- 10°
— 15°
---- 20°
······ 25°

(b)

$\lambda_{PL}$  $\lambda$off  $\lambda$on

Relative Intensity

Wavelength [nm]

— 0°
--- 10°
— 15°
---- 20°
······ 25°

(c)

Relative Intensity

$\lambda_{EL}$

Wavelength [nm]

(d)

Relative Intensity

$\lambda_{EL}$

Wavelength [nm]

EP 4 326 005 A1

FIG. 6A

$n_0$

$n_1$

$\theta_0$

$\psi$

$\Delta$ML

$n_2$

$\lambda_{PL}$

$n_{eml}$

$n_1 = n_2 = n_{eml}$

FIG. 6B

$\theta'_0$

$\psi'$

$\Delta$ML

$\Theta_{eml}$

$\lambda_{PL}$

$n_1 = n_2 = n_{eml}$

# FIG. 7A

# FIG. 7B

# FIG. 8A

A •————————————————————————• A'

# FIG. 8B

A •————————————————————————• A'

# FIG. 8C

# FIG. 8D

# FIG. 9

# FIG. 10

# FIG. 11

1001

1002

1003

1004

1005

1006

1007

1008

1009

1000

## FIG. 12A

## FIG. 12B

## FIG. 13A

1300

1301  1302

1303

## FIG. 13B

1310

1314

1312

1311

1313

# FIG. 14A

1600

1603

1601

1602

# FIG. 14B

1610

1612

1611

## INTERNATIONAL SEARCH REPORT

| International application No. |
|---|
| **PCT/JP2022/015552** |

**A. CLASSIFICATION OF SUBJECT MATTER**

*H05B 33/24*(2006.01)i; *G09F 9/30*(2006.01)i; *H01L 27/32*(2006.01)i; *H01L 51/50*(2006.01)i; *H05B 33/02*(2006.01)i; *H05B 33/22*(2006.01)i
FI: H05B33/24; H05B33/14 A; H05B33/22 Z; H01L27/32; G09F9/30 365; H05B33/02

According to International Patent Classification (IPC) or to both national classification and IPC

**B. FIELDS SEARCHED**

Minimum documentation searched (classification system followed by classification symbols)

H05B33/24; G09F9/30; H01L27/32; H01L51/50; H05B33/02; H05B33/22

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2012-134128 A (CANON INC.) 12 July 2012 (2012-07-12) paragraphs [0014]-[0069], [0085]-[0119], fig. 1 | 1-12, 16-22, 25-27 |
| Y | paragraphs [0014]-[0069], [0085]-[0119], fig. 1 | 13-15, 23-24 |
| Y | US 2019/0165052 A1 (LG DISPLAY CO., LTD.) 30 May 2019 (2019-05-30) paragraphs [0060]-[0061], [0071], fig. 10 | 13-15, 23-24 |

☐ Further documents are listed in the continuation of Box C.　　☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **09 June 2022** | **21 June 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT
### Information on patent family members

International application No.

**PCT/JP2022/015552**

| Patent document cited in search report | | | Publication date (day/month/year) | Patent family member(s) | | Publication date (day/month/year) |
|---|---|---|---|---|---|---|
| JP | 2012-134128 | A | 12 July 2012 | US 2012/0133575 A1 paragraphs [0017]-[0066], [0083]-[0111], fig. 1 CN 102479799 A | | |
| US | 2019/0165052 | A1 | 30 May 2019 | KR 10-2019-0063609 A CN 110034154 A | | |

Form PCT/ISA/210 (patent family annex) (January 2015)

**EP 4 326 005 A1**

REFERENCES CITED IN THE DESCRIPTION

**Patent documents cited in the description**

- JP 2017017013 A
- JP 2021067635 A
- JP 2022018103 A